# EUROPEAN PATENT APPLICATION

(11) **EP 4 730 565 A1**
(43) Date of publication of application: **22.04.2026**
(21) Application number: 24832517.7
(22) Date of filing: 28.06.2024
(51) Int. Cl.: H01Q 21/08, H01Q 9/04, H01Q 1/24, H01Q 13/10, H01Q 5/30, H04M 1/02, H05K 1/18

(54) **ELECTRONIC DEVICE COMPRISING ANTENNA**

(30) Priority: 30.06.2023 KR 20230085399; 16.08.2023 KR 20230107265
(71) Applicant: Samsung Electronics Co., Ltd., Suwon-si, Gyeonggi-do 16677 (KR)
(72) Inventor: YUN, Sumin, Suwon-si Gyeonggi-do 16677 (KR); KIM, Hosaeng, Suwon-si Gyeonggi-do 16677 (KR); PARK, Seongjin, Suwon-si Gyeonggi-do 16677 (KR); LEE, Hyungjoo, Suwon-si Gyeonggi-do 16677 (KR)
(74) Representative: HGF
(86) International application number: PCT/KR2024/009132
(87) International publication number: WO 2025/005741

(57) **Abstract**

In embodiments, an electronic device is provided. The electronic device may comprise: a printed circuit board (PCB); a support member including a first portion coupled to the PCB, a second portion opposite to the first portion, and a side portion between the first portion and the second portion; a wireless communication circuit disposed on the PCB; and a plurality of conductive patches disposed on one surface of the side portion. The plurality of conductive patches may be electrically connected to the wireless communication circuit. Each conductive patch of the plurality of conductive patches may be configured to transmit or receive circularly polarized signals in the frequency band of the wireless communication circuit. The first portion of the support member or the second portion of the support member may be coupled to a metal layer.

## Description

### [Technical Field]

The present disclosure relates to an electronic device including an antenna.

### [Background Art]

An electronic device may transmit a signal through an antenna or receive a signal through an antenna. The electronic device may include a conductive patch. The conductive patch may operate as an antenna radiator for transmitting and/or receiving a signal.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, an electronic device is provided. The electronic device may comprise a printed circuit board (PCB), a support including a first portion coupled to the PCB, a second portion opposite to the first portion, and a side portion between the first portion and the second portion, wireless communication circuitry disposed on the PCB, and a plurality of conductive patches disposed on a surface of the side portion of the support. The plurality of conductive patches may be electrically connected to the wireless communication circuitry. Each conductive path of the plurality of conductive patches may be configured to transmit or receive a signal of a circular polarization in a frequency band of the wireless communication circuitry. The first portion of the support or the second portion of the support may be coupled to a metal layer.

In embodiments, an electronic device is provided. The electronic device may comprise a communication module for a designated frequency band, and a housing including a first plate for supporting the electronic device and a second plate opposite to the first plate. The communication module may include a printed circuit board (PCB), a support including a first portion coupled to the PCB, a second portion opposite to the first portion, and a side portion disposed in a space between the first portion and the second portion, and communication circuitry disposed on the PCB. The electronic device may include a plurality of conductive patches disposed on a surface of the side portion of the support. The plurality of conductive patches may be electrically connected to the communication circuitry. Each conductive path of the plurality of conductive patches may be configured to transmit or receive a signal of a circular polarization in a frequency band of the wireless communication circuitry. A metal layer may be disposed between the support and the first plate of the housing.

### [Description of the Drawings]

FIG. 1 is a block diagram of an electronic device in a network environment.
FIG. 2 indicates an example of a communication environment of an electronic device.
FIG. 3 indicates an example of a housing and a communication module of an electronic device.
FIGS. 4A to 4C indicate an example of a communication module of an electronic device.
FIGS. 5A to 5E indicate examples of a connection structure of a conductive patch of an electronic device.
FIG. 6 indicates a relationship of an image current on a metal surface according to a current direction.
FIGS. 7A to 7C indicate examples of a metal layer of an electronic device.
FIG. 8A indicates an example of a performance of conductive patches of an electronic device.
FIG. 8B indicates an example of a recognition distance performance according to a material of a bottom surface of an electronic device.
FIGS. 9A to 9B indicate an example of a conductive patch for a circular polarization.
FIGS. 10A to 10C indicate other examples of a conductive patch for a circular polarization.
FIG. 11A indicates an example of a radiation pattern for each polarization.
FIG. 11B indicates an example of a gain for each frequency.
FIG. 12 indicates an example of directivity according to a distance between an antenna and a metal layer.
FIGS. 13A to 13B indicate examples of a radiation pattern according to a polarization and a wavelength.
FIGS. 14A to 14D indicate an example of a wearable device including a conductive patch for a circular polarization.
FIGS. 15A to 15B indicate an example of a speaker device including a conductive patch for a circular polarization.
FIGS. 16A and 16B indicate an example of a tag device including a conductive patch for a circular polarization.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a component of an electronic device (e.g., a substrate, a printed circuit board (PCB), a flexible PCB (FPCB), a module, an antenna, an antenna element, circuitry, a processor, a chip, a component, a device), a term referring to a shape of a component (e.g., a structure body, a structure, a support portion, a contact portion, a protrusion), a term referring to a connection portion between structure bodies (e.g., a connection portion, a contact portion, a support portion, a contact structure, a conductive member, an assembly), a term referring to circuitry (e.g., a PCB, an FPCB, a signal line, a feeding line, a data line, an RF signal line, an antenna line, an RF path, an RF module, RF circuitry, a splitter, a divider, a coupler, a combiner), and the like, used in the following description, are exemplified for convenience of explanation. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

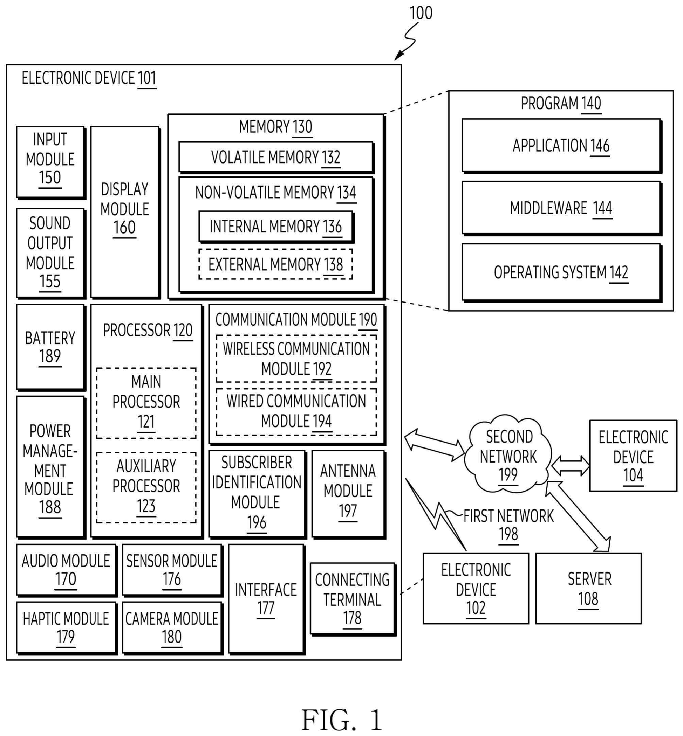

FIG. 1 is a block diagram of an electronic device in a network environment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

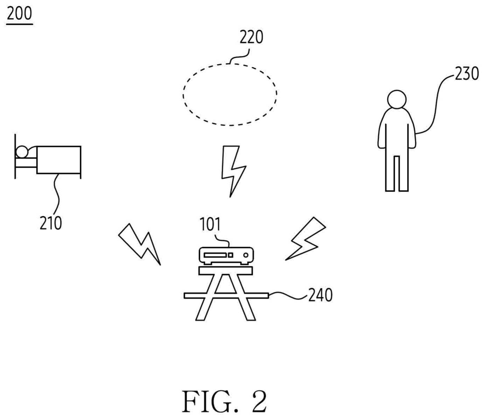

FIG. 2 indicates an example of a communication environment of an electronic device (e.g., an electronic device 101). As the number of devices supporting an ultra-wide band (UWB) band increase, various services are used. A tag device for a service for finding a target object, or a digital key service that automatically opens the door when approaching nearby, and the like, is provided through the UWB band.

Referring to FIG. 2, an electronic device 101 may transmit or receive a signal in the UWB band. The electronic device 101 may provide various services based on the signal. For example, the electronic device 101 may provide a sleep detection service. The electronic device 101 may use a radar function based on the signal. The electronic device 101 may transmit a signal to a target object 210, which is a user in sleep. The electronic device 101 may receive a signal reflected from the target object. The electronic device 101 may obtain information (e.g., a person's location, a breathing pattern, and a heart rate) on the target object 210 based on the reflected signal. The electronic device 101 may detect a respiratory state based on an analysis result of the information. For example, the electronic device 101 may provide an occupancy detection service. The electronic device 101 may transmit a signal to a specific region 220 and check whether a person is present in the specific region 220 through whether the signal is reflected. As an example, the electronic device 101 may detect an intruder in the specific region 220. For example, the electronic device 101 may provide gesture sensing. The electronic device 101 may transmit a signal through a transmission antenna and receive a signal reflected from a user 230 through a reception antenna. The electronic device 101 may identify a gesture of the user 230 by analyzing the received signal. According to the gesture of the user 230, the electronic device 101 may perform a designated operation. The user 230 may control the electronic device 101 through the gesture.

The electronic device 101 may be disposed above a surface of a table 240. A mounting-type device such as a hub device may be disposed above a surface of various places such as a table, a TV cabinet, a bed, and the like. A performance of the electronic device 101 may be changed according to an environment of a location that is mounted. Therefore, in order to provide a stable service environment, it is required that a communication quality of the electronic device 101 does not change significantly according to the environment of the location that is mounted. The surface of the table 240 may be formed of at least one of various materials. If an antenna is designed as a sidewall of the electronic device 101 or as an upper end of the electronic device 101, since a predetermined separation distance between a bottom surface and the antenna is secured, an impedance change of the antenna does not change significantly. However, a radiation pattern of the antenna undergoes a large change, a problem in a radar function according an environment may be caused. The electronic device 101 may be required to secure a certain level of performance or higher even on a floor or a table of any material.

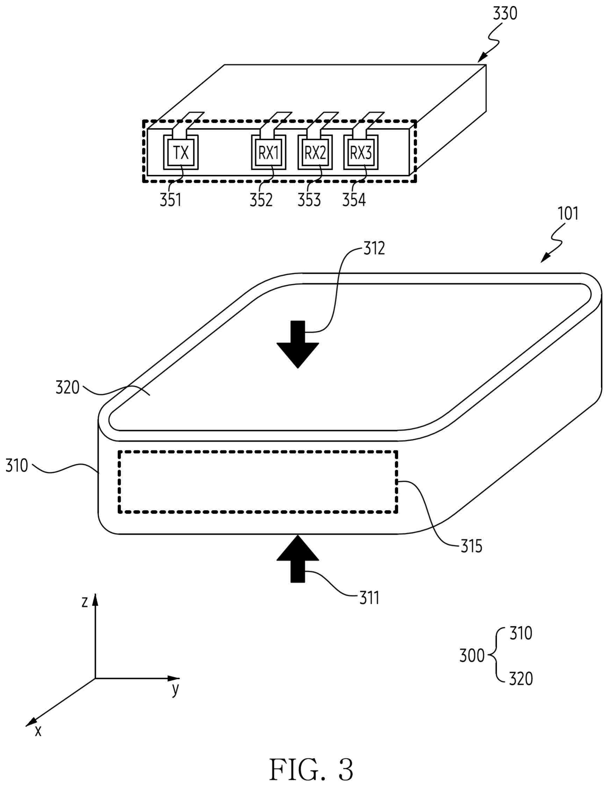

FIG. 3 indicates an example of a housing and a communication module of an electronic device (e.g., the electronic device 101). The electronic device 101 may transmit or receive a signal in a designated frequency band (e.g., a UWB band). The electronic device 101 may provide a service using a radar based on the signal.

Referring to FIG. 3, the electronic device 101 may include a housing 300. The housing 300 may include a first plate 311 facing a -z axis. The electronic device 101 may be supported from a bottom surface through the first plate 311 of the housing 300. The first plate 311 of the housing 300 may be in contact with the bottom surface. The housing 300 may include a second plate 312 facing a +z axis. The housing 300 may include a case 310 and a cover 320. The case 310 may be configured to accommodate a communication module 330. The case 310 may include the first plate 311 of the housing 300. A side surface 315 of the case 310 may be a region in which antennas 351, 352, 353, and 354 are disposed. The antennas 351, 352, 353, and 354 may be located in a region corresponding to the side surface 315. The electronic device 101 may be configured to transmit or receive a signal through the side surface 315. For example, the transmission antenna 351 may be configured to transmit a signal in the designated frequency band (e.g., the UWB band) through the side surface 315. For example, the first reception antenna 352, the second reception antenna 353, and/or the third reception antenna 354 may be configured to receive a signal in the designated frequency band (e.g., the UWB band) through the side surface 315. The cover 320 may be configured to cover the communication module 330 in the case 310. The cover 320 may include the second plate 312 of the housing 300.

A service (e.g., occupancy detection, or sleep monitoring) using the UWB band provide detection for a specific direction. For a radar function, the electronic device 101 may include a structure in which radiators (e.g., the antennas 351, 352, 353, and 354) are disposed on the side surface 315. The electronic device 101 using the radar function may transmit a signal in the UWB band. The signal is reflected from an object. The electronic device 101 may receive the reflected signal. Since the electronic device 101 should receive the reflected signal after transmitting the signal, coupling between the transmission antenna and the reception antenna may occur. The electronic device 101 is required to secure isolation between the antennas. For example, for directionality, the electronic device 101 may use conductive patches as an antenna. In order to secure the isolation between the transmission antenna (e.g., the transmission antenna 351) and the reception antenna (e.g., the first reception antenna 352, the second reception antenna 353, and/or the third reception antenna 354), the conductive patches may be disposed by being spaced apart from each other by more than half a wavelength of the signal. Although three reception antennas have been illustrated in FIG. 3, embodiments of the present disclosure are not limited thereto. The number of reception antennas of the electronic device 101 may vary according to a required service. For example, an antenna structure implemented as a pair of the transmission antenna and the reception antenna may also be understood as an embodiment of the present disclosure.

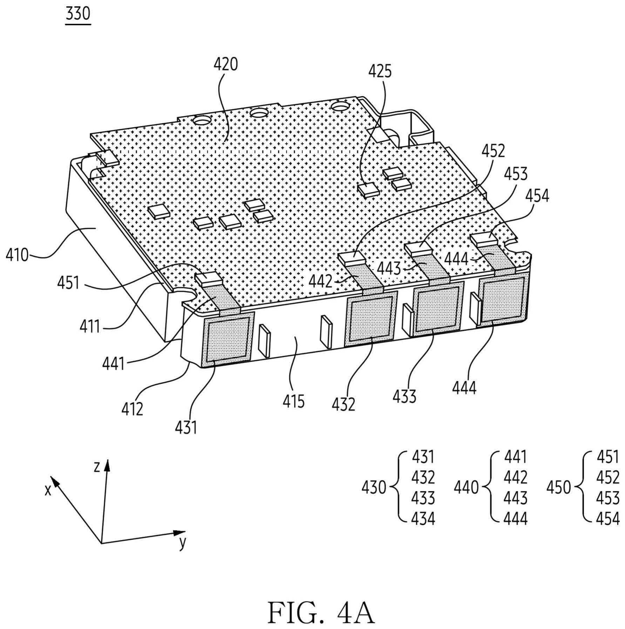

FIGS. 4A to 4C indicate an example of a communication module (e.g., a communication module 330) of an electronic device (e.g., an electronic device 101).

Referring to FIG. 4A, the electronic device 101 may include a support 410, a PCB 420, wireless communication circuitry 425, conductive patches 430, a connection structure 440, and a connector 450. The support 410 may include a first portion 411 (e.g., a region/surface/portion facing a +z axis), a second portion 412 (e.g., a region/surface/portion facing a -z axis), and a side portion 415 between the first portion 411 and the second portion 412. The first portion 411 of the support 410 may be configured to be coupled to the PCB 420. For example, the first portion 411 of the support 410 may include a region of the support 410 exposed to an upper portion when viewed from above with respect to a z axis direction. The support 410 may include sidewall portions forming a predetermined height to support the PCB 420 substrate. A region of the sidewall portions may be configured such that the PCB 420 is mounted thereon. For example, the first portion 411 of the support 410 may include a surface facing the +z axis. The support 410 may support the PCB 420 substrate and may include a support structure in which the inside is filled. The PCB 420 may be coupled to a surface of the support. The second portion 412 of the support 410 may be located in an opposite side of the first portion 411 of the support 410. For example, the second portion 412 of the support 410 may be a region opposite to a region to which the PCB 420 substrate is coupled among the sidewall portions formed to support the PCB 420. For example, the second portion 412 of the support 410 may include a surface opposite to the surface to which the PCB 420 is coupled among the support structure.

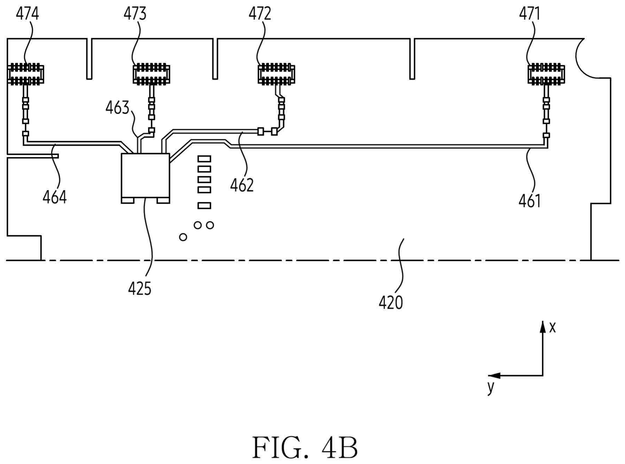

The PCB 420 may be used for a disposition and a connection of electronic components. One or more components and wiring for transmitting a signal in a designated frequency band (e.g., a UWB band) may be disposed above a surface of the PCB 420. For example, the wireless communication circuitry 425 for the designated frequency band may be disposed above a surface of the PCB 420. The wireless communication circuitry 425 may include a UWB integrated circuit (IC). A conductive pattern for an electrical connection between the wireless communication circuitry 425 and the conductive patches 430 may be formed above a surface of the PCB 420. The disposition on the PCB 420 will be described in detail through FIG. 4B.

The conductive patches 430 may include a first conductive patch 431, a second conductive patch 432, a third conductive patch 433, and a fourth conductive patch 434. A conductive patch, which is a patch that generates an electromagnetic wave as a signal is fed to a shape, may be referred to as a conductive patch, a radiation patch, a metal patch, a conductive substrate, a conductive sheet, or an equivalent technical term thereto. Each conductive patch of the conductive patches 430 may be configured to transmit or receive a wireless signal. For example, the first conductive patch 431 may be configured to transmit a signal in the UWB band. The second conductive patch 432, the third conductive patch 433, and/or the fourth conductive patch 434 may be configured to receive a signal in the UWB band.

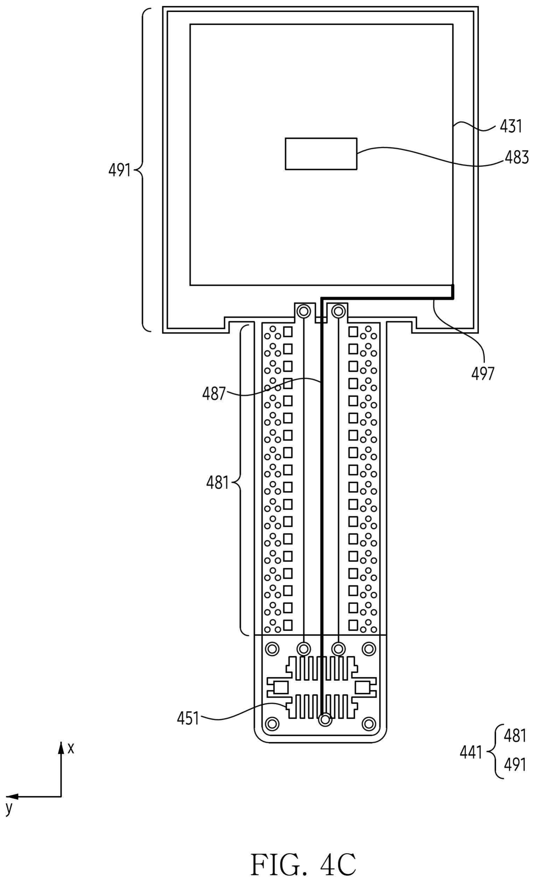

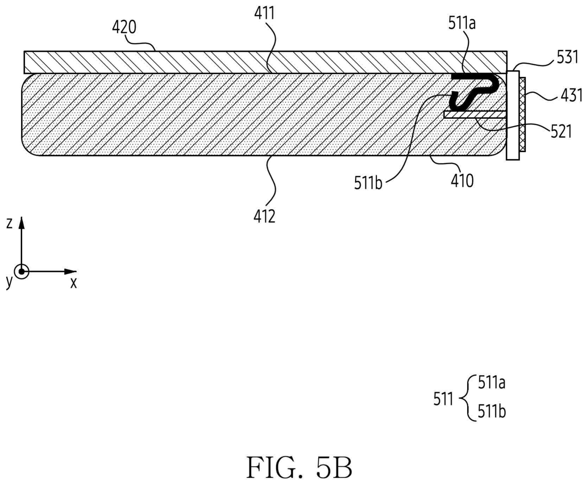

The connection structure 440 may be configured to connect the PCB 420 and the conductive patches 430. According to an embodiment, the connection structure 440 may include a flexible print circuit board (FPCB). For example, a first FPCB 441 may be connected to the first conductive patch 431. A second FPCB 442 may be connected to the second conductive patch 432. A third FPCB 443 may be connected to the third conductive patch 433. A fourth FPCB 444 may be connected to the fourth conductive patch 434. A connection structure between a conductive patch (e.g., the first conductive patch 431) and the PCB through the FPCB 420 will be described in detail through FIG. 4C. Although the FPCB has been illustrated as an example of the connection structure 440 in FIG. 4A, embodiments of the present invention are not limited thereto. For example, the connection structure 440 may include a C-clip that is disposed on the PCB 420 and is for providing an electrical connection to a conductive patch. For description of the C-clip, FIG. 5B may be referred to. In addition, for example, the connection structure 440 may include a conductive member (e.g., a bracket, or a protrusion) between the PCB 420 and a conductive patch. For description of the conductive member, FIG. 5B may be referred to.

The connector 450 may be configured to connect the PCB 420 and the connection structure 440. For example, the PCB 420 may include a conductive pattern for an electrical connection with the wireless communication circuitry 425. The connector 450 may be configured to connect an end portion of the conductive pattern and the connection structure 440. For example, a first connector 451 may connect the first FPCB 441 and the PCB 420. A second connector 452 may connect the second FPCB 442 and the PCB 420. A third connector 453 may connect the third FPCB 443 and the PCB 420. A fourth connector 454 may connect the fourth FPCB 444 and the PCB 420.

In FIG. 4A, although an example where the conductive patches 430 are attached to the side portion 415 of the support 410 has been illustrated, embodiments of the present disclosure are not limited thereto. If it is an antenna radiated in a lateral direction, descriptions of the present disclosure may be applied. According to an embodiment, a plating pattern (e.g., a laser direct structuring (LDS) pattern) may be formed in a region of the side portion 415 of the support 410. According to another embodiment, a chip antenna or a printed embedded antenna (PEA) may be disposed in the side portion 415 of the support 410.

Referring to FIG. 4B, FIG. 4B is a diagram of the electronic device 101 of FIG. 4A viewed from a +z axis direction to a -z axis direction. The wireless communication circuitry 425 may be disposed above a surface of the PCB 420. A conductive pattern (e.g., a first conductive pattern 461, a second conductive pattern 462, a third conductive pattern 463, and a fourth conductive pattern 464) for electrically connecting the wireless communication circuitry 425 and each conductive patch (e.g., the first conductive patch 431, the second conductive patch 432, the third conductive patch 433, and the fourth conductive patch 434) may be disposed above the surface of the PCB 420. The first conductive pattern 461 may be configured to electrically connect the first conductive patch 431 and the wireless communication circuitry 425. A first end portion 471 of the first conductive pattern 461 may be configured to be coupled to the first connector 451. The wireless communication circuitry 425 may supply a transmission signal to the first conductive patch 431 through the first conductive pattern 461 and the first connector 451. The second conductive pattern 462 may be configured to electrically connect the second conductive patch 432 and the wireless communication circuitry 425. A second end portion 472 of the second conductive pattern 462 may be configured to be coupled to the second connector 452. The wireless communication circuitry 425 may obtain a reception signal from the second conductive patch 432 through the second conductive pattern 462 and the second connector 452. The third conductive pattern 463 may be configured to electrically connect the third conductive patch 433 and the wireless communication circuitry 425. A third end portion 473 of the third conductive pattern 463 may be configured to be coupled to the third connector 453. The wireless communication circuitry 425 may obtain a reception signal from the third conductive patch 433 through the third conductive pattern 463 and the third connector 453. The fourth conductive pattern 464 may be configured to electrically connect the fourth conductive patch 434 and the wireless communication circuitry 425. A fourth end portion 474 of the fourth conductive pattern 464 may be configured to be coupled to the fourth connector 454. The wireless communication circuitry 425 may obtain a reception signal from the fourth conductive patch 434 through the fourth conductive pattern 464 and the fourth connector 454.

Referring to FIG. 4C, an FPCB is described as an example of the connection structure 440. The FPCB may be connected to a conductive patch. Although the first FPCB 441 of the communication module 330 is described as an example, the following descriptions may be applied to the second FPCB 442, the third FPCB 443, and/or the fourth FPCB 444. The first FPCB 441 may be configured with a flexible material. The first FPCB 441 may include a cable portion 481 and a plate portion 491. The cable portion 481 may include a flexible structure to be robust against an external force such as twisting, torsion, bending, and the like. The cable portion 481 may be electrically connected to the wireless communication circuitry 425 through the first connector 451. For example, the cable portion 481 may be coupled to the first end portion 471 of the first conductive pattern 461 of the PCB 420 through the first connector 451. The cable portion 481 may include a feeding line 487. A signal may be transmitted to the first conductive patch 431 through the feeding line 487. The plate portion 491 may include a region for the first conductive patch 431. The first conductive patch 431 may be disposed above a surface of the plate portion 491. The plate portion 491 may include a feeding line 497 for providing a signal to the first conductive patch 431. The feeding line 497 may be connected to the feeding line 487 of the cable portion 481. The feeding line 497 may provide a region (e.g., a feeding point) for a circular polarization of the first conductive patch 431 with a signal. The first conductive patch 431 may be configured to radiate a signal of the circular polarization.

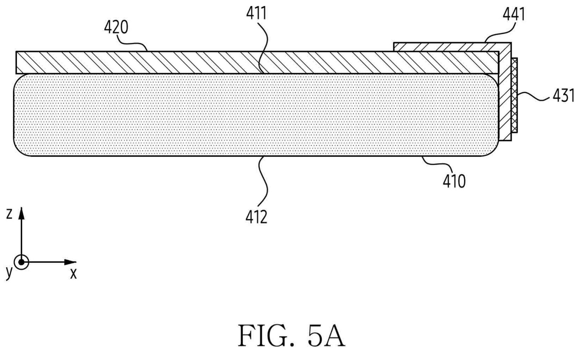

FIGS. 5A to 5E indicate examples of a connection structure of a conductive patch of an electronic device (e.g., an electronic device 101). In FIGS. 5A to 5C, examples of a connection structure 440 for electrically connecting a PCB (e.g., a PCB 420) and a conductive patch (e.g., a first conductive patch 431) are described. Hereinafter, the first conductive patch 431 is described as a reference, but corresponding descriptions may be equally applied to other conductive patches (e.g., a second conductive patch 432, a third conductive patch 433, and/or a fourth conductive patch 434).

Referring to FIG. 5A, the connection structure 440 may include a first FPCB 441. The first conductive patch 431 may be disposed above a surface (e.g., a surface facing a +x axis) of the first FPCB 441. A conductive pattern (e.g., a first conductive pattern 461) of the PCB 420 may provide the first conductive patch 431 with a signal through the first FPCB 441. The first conductive patch 431 may transmit a signal in a lateral direction (e.g., a +x axis direction).

Referring to FIG. 5B, the connection structure 440 may include a C-clip 511. The C-clip 511 may include a substrate portion 511a and a contact portion 511b. The substrate portion 511a of the C-clip 511 may be disposed above a surface (e.g., a surface facing a -z axis) of the PCB 420. At least a portion of the contact portion 511b of the C-clip 511 may have elasticity. Through a pressure in a z-axis direction, the contact portion 511b of the C-clip 511 may be in contact with a metal structure 521. The metal structure 521 may be electrically connected to a substrate 531. The first conductive patch 431 may be disposed above a surface of the substrate 531. The PCB 420 and the first conductive patch 431 may be electrically connected to each other through a contact between the contact portion 511b and the metal structure 521. The PCB 420 may provide the first conductive patch 431 with a signal through the C-clip 511, the metal structure 521, and the substrate 531. For example, for an electrical connection from wireless communication circuitry 425, a conductive pattern may be formed above a surface (e.g., a surface facing the -z axis) of the PCB 420 or a via may be disposed across layers of the PCB 420. The first conductive patch 431 may transmit a signal in the lateral direction (e.g., the +x axis direction). In FIG. 5B, it has been described that the metal structure 521 and the first conductive patch 431 are electrically connected through the substrate 531, but embodiments of the present disclosure are not limited thereto. The metal structure 521 in contact with the C-clip 511 being directly connected to the first conductive patch 431 may also be understood as an embodiment of the present disclosure.

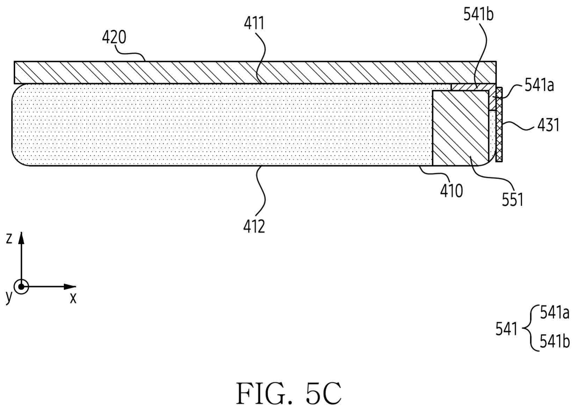

Referring to FIG. 5C, the connection structure 440 may include a conductive member 541. An injection portion of a support 410 may include a non-conductive portion 551. The conductive member 541 may be coupled to the non-conductive portion 551. For example, the non-conductive portion 551 of the support 410 may be disposed to support the conductive member 541. The conductive member 541 may include a first portion 541a and a second portion 541b. For example, the conductive member 541 may include a metal bracket. The first portion 541a may be coupled to a surface (e.g., a surface facing the -z axis) of the PCB 420. The second portion 541b may be coupled to the first conductive patch 431. The PCB 420 may provide the first conductive patch 431 with a signal through the first portion 541a and the second portion 541b of the conductive member 541. For example, for the electrical connection from the wireless communication circuitry 425, the conductive pattern may be formed above the surface (e.g., the surface facing the -z axis) of the PCB 420 or the via may be disposed across the layers of the PCB 420. The first conductive patch 431 may transmit a signal in the lateral direction (e.g., the +x axis direction). In FIG. 5B, although the conductive member 541 having an '¬' shape has been illustrated, embodiments of the present disclosure are not limited thereto. If it is a shape that is configured with a conductive material and is for connecting the first conductive patch 431 disposed to face the surface (e.g., the surface facing the -z axis) of the PCB 420 and a radiation surface (e.g., a surface facing a +z axis), it may be understood as an embodiment of the present disclosure.

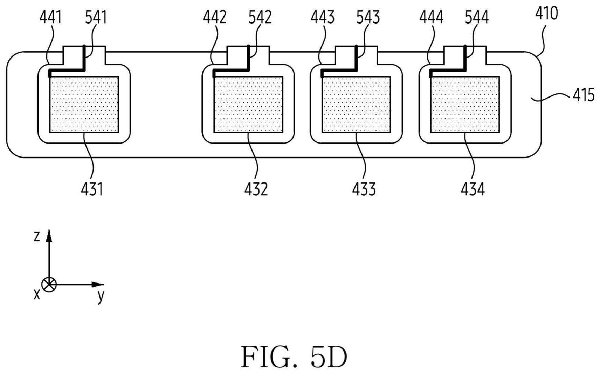

In FIGS. 5D to 5E, disposition examples between the FPCB and a conductive patch are described. Since services using a radar function are provided based on a direction of a target object, the electronic device 101 may be disposed such that antennas face the lateral direction (e.g., a +x axis direction) based on a bottom surface.

Referring to FIG. 5D, conductive patches 430 may be disposed above a side portion 415 of the support 410. In order to be electrically connected to the PCB 420 disposed to face a direction (e.g., a +z axis direction) and to be disposed on the side portion 415 facing the lateral direction (e.g., the +x-axis direction), a flexible connection structure (e.g., FPCB) may be used. In order to secure isolation between the conductive patches 430, adjacent conductive patches may be spaced apart by more than half a wavelength of a transmitted or received signal. Each conductive patch may be electrically connected to the PCB 420 through a feeding line (e.g., a feeding line 487 and a feeding line 497) within the FPCB. For example, the first FPCB 441 may be coupled to the first conductive patch 431 and the PCB 420. A first feeding line 561 for transmitting a signal to the first conductive patch 431 may be disposed in the first FPCB 441. The second FPCB 441 may be coupled to the second conductive patch 432 and the PCB 420. A second feeding line 562 for receiving a signal through the second conductive patch 432 may be disposed in the second FPCB 442. The third FPCB 441 may be coupled to the third conductive patch 433 and the PCB 420. A third feeding line 563 for receiving a signal through the third conductive patch 433 may be disposed in the third FPCB 443. The fourth FPCB 444 may be coupled to the fourth conductive patch 434 and the PCB 420. A fourth feeding line 564 for receiving a signal through the fourth conductive patch 434 may be disposed in the fourth FPCB 444.

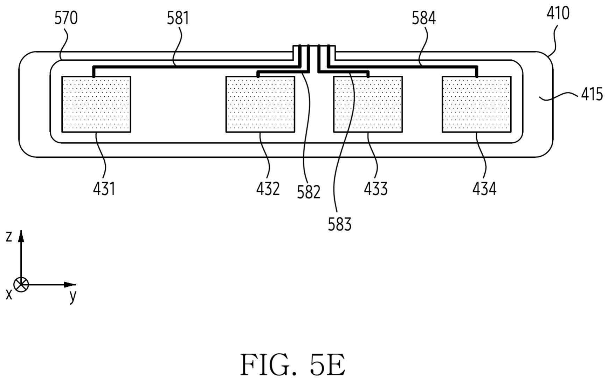

Referring to FIG. 5E, the conductive patches 430 may be disposed above the side portion 415 of the support 410. In order to be electrically connected to the PCB 420 disposed to face a direction (e.g., the +z axis direction) and to be disposed on the side portion 415 facing the lateral direction (e.g., the +x axis direction), a flexible connection structure (e.g., FPCB) may be used. In order to secure isolation between the conductive patches 430, adjacent conductive patches may be spaced apart by more than half a wavelength of a transmitted or received signal. Unlike FIG. 5E, a substrate 570 for the conductive patches 430 may be disposed on the side portion 415. For example, the substrate 570 may include an FPCB. Each conductive patch may be electrically connected to the PCB 420 through feeding lines in the substrate 570. For example, the substrate 570 may be coupled to the conductive patches 430 and the PCB 420. A first feeding line 581 for transmitting a signal to the first conductive patch 431 may be disposed in the substrate 570. A second feeding line 582 for receiving a signal through the second conductive patch 432 may be disposed in the substrate 570. A third feeding line 583 for receiving a signal through the third conductive patch 433 may be disposed in the substrate 570. A fourth feeding line 584 for receiving a signal through the fourth conductive patch 434 may be disposed in the substrate 570. The substrate 570 may be connected to a conductive pattern formed above a surface of the PCB 420 through a connector. The conductive pattern may include a conductive pattern for the first conductive patch 431, a conductive pattern for the second conductive patch 432, a conductive pattern for the third conductive patch 433, and a conductive pattern for the fourth conductive patch 434. As all of the conductive patches 430 are connected to the PCB 420 through the substrate 570, an antenna connection structure may be simplified.

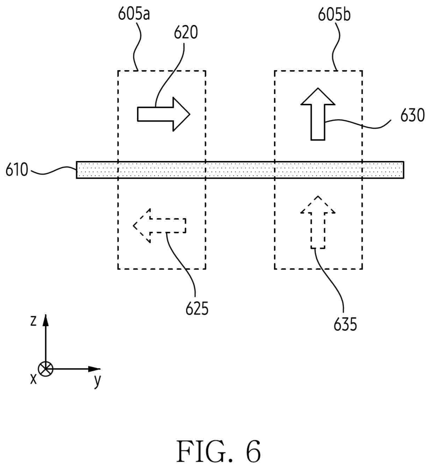

FIG. 6 indicates a relationship of an image current on a metal surface according to a current direction. In FIG. 6, in order to explain a gain for a signal of a circular polarization, a principle in which an image current is formed according to a current direction of an antenna and a metal surface is described.

Referring to FIG. 6, as a signal is supplied to an antenna 605a, a first current 620 may flow on a radiator in a first direction (e.g., a + y axis direction). The first current 620 may flow in the first direction (e.g., the + y axis direction) at a location spaced apart from a metal surface 610 by a predetermined distance. According to a boundary condition with respect to metal, an electric field does not exist inside the metal, but charge density may exist on a surface of the metal. As electrons move on the surface of the metal, the charge density may vary. According to the boundary condition, a first image current 625 may flow in a second direction (e.g., a -y axis direction) opposite to the first direction due to the first current 620 above the metal surface 610. In other words, a current flowing in a direction (e.g., the first current 620) parallel to the metal surface 610 may generate an image current (e.g., the first image current 625) in a different direction. As the current and the image current flow in opposite directions, antenna efficiency may decrease.

As a signal is supplied to an antenna 605b, a second current 630 may flow on the radiator in a third direction (e.g., in a +z axis direction). The second current 630 may flow in the third direction (e.g., the +z axis direction) at a location spaced apart from the metal surface 610 by a predetermined distance. Based on the boundary condition, due to the second current 630 above the metal surface 610, a second image current 635 may flow in the same direction as the third direction. In other words, a current (e.g., the second current 630) flowing in a direction perpendicular to the metal surface 610 may generate an image current (e.g., the second image current 635) in the same direction. As the current and the image current flow in the same direction, antenna efficiency may increase.

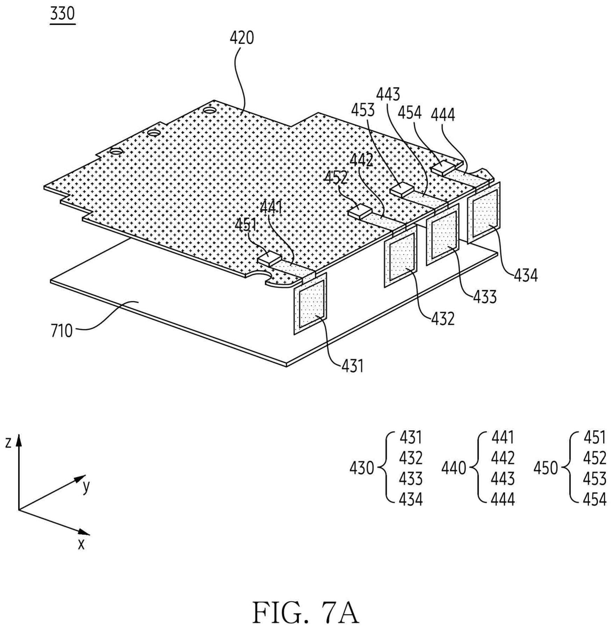

The electronic device 101 may include a metal layer corresponding to the metal surface 610 in order to reduce a change in a performance due to a material of a bottom surface. The electronic device 101 may include fewer antenna structures. As described in FIG. 6, an antenna disposed with a height on the metal surface 610 may be configured to radiate a signal (e.g., a signal of the circular polarization) having a vertical polarization component to increase the antenna efficiency. Considering an effect of a radiation pattern due to the antenna efficiency and the bottom surface, the electronic device 101 may include a metal layer disposed on a lower region (e.g., a first plate 311 of a housing 300, a first portion 411 of a support 410, or a second portion 412 of the support 410) spaced apart from the antenna by a predetermined distance. Hereinafter, examples in which the metal layer is disposed on the bottom surface will be described through FIGS. 7A to 7C.

FIGS. 7A to 7C indicate examples of a metal layer of an electronic device (e.g., an electronic device 101). In order to reduce a performance difference between materials of a bottom surface and to utilize an effect of gain improvement by a metal layer (e.g., a metal surface 610), the metal layer may be disposed on a lower region (e.g., a first plate 311 of a housing 300) of the electronic device 101. For example, the metal layer may be disposed above the first plate 311 of the housing 300 in a +z axis direction.

Referring to FIG. 7A, according to an embodiment, the electronic device 101 may include a support 410, a PCB 420, wireless communication circuitry 425, conductive patches 430, a connection structure 440, a connector 450 and a ground substrate 710. For description of the support 410, the PCB 420, the wireless communication circuitry 425, the conductive patches 430, the connection structure 440, and the connector 450, FIG. 4A may be referred to. A first portion 411 of the support 410 may be configured to be coupled to the PCB 420. The support 410 may include sidewall portions forming a predetermined height to support a PCB 420 substrate. A second portion 412 of the support 410 may be located in an opposite side of the first portion 411 of the support 410. The ground substrate 710 may be used to reduce electrical noise of electronic components. For example, the ground substrate 710 may be configured with a copper or aluminum material. The second portion 412 of the support 410 may be coupled to the ground substrate 710. For example, when viewed from bottom to top based on a z axis direction, the ground substrate 710 may be coupled to the support 410. The ground substrate 710 may be located below with respect to the conductive patches 430 disposed on a side portion 415. Although not illustrated in FIG. 7A, the ground substrate 710 may be disposed above the first plate 311 of the housing 300.

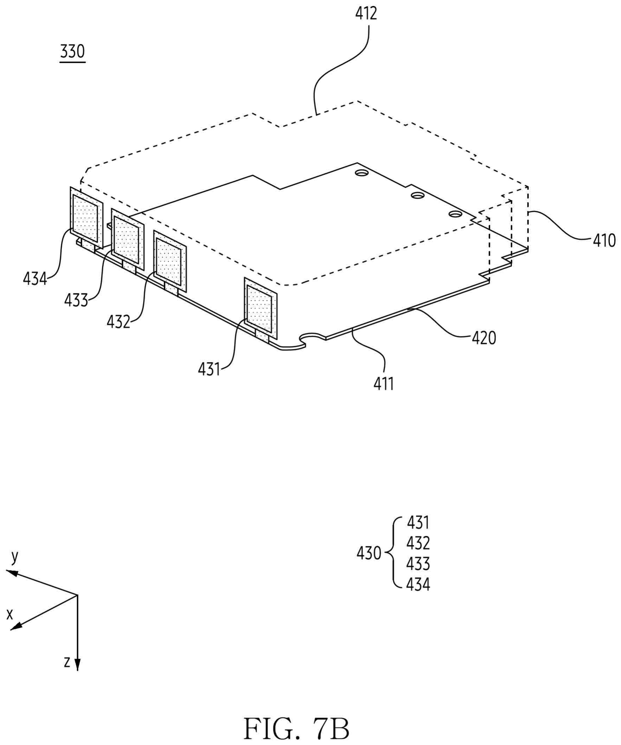

Referring to FIG. 7B, according to an embodiment, the electronic device 101 may include the support 410, the PCB 420, the wireless communication circuitry 425, the conductive patches 430, the connection structure 440, the connector 450 and the ground substrate 710. For the description of the support 410, the PCB 420, the wireless communication circuitry 425, the conductive patches 430, the connection structure 440, and the connector 450, FIG. 4A may be referred to. The PCB 420 may be used to configure electrical circuitry of electronic components. The PCB 420 may be configured with various materials (e.g., glass fiber, epoxy resin, and copper foil). At least a portion of the PCB 420 may include a metal layer. For example, an electronic component may be disposed above a surface of the PCB 420, and a conductive pattern for an electrical connection between the electronic component and another electronic component may be formed. The surface may include a metal layer configured with a metal material to form electrical circuitry. As the surface of the PCB 420 is disposed to face a -z axis direction, the metal layer of the PCB 420 may be located below with respect to the conductive patches 430 disposed on the side portion 415. The PCB 420 may be used as ground. Although not illustrated in FIG. 7B, the metal layer of the PCB 420 may be disposed above the first plate 311 of the housing 300.

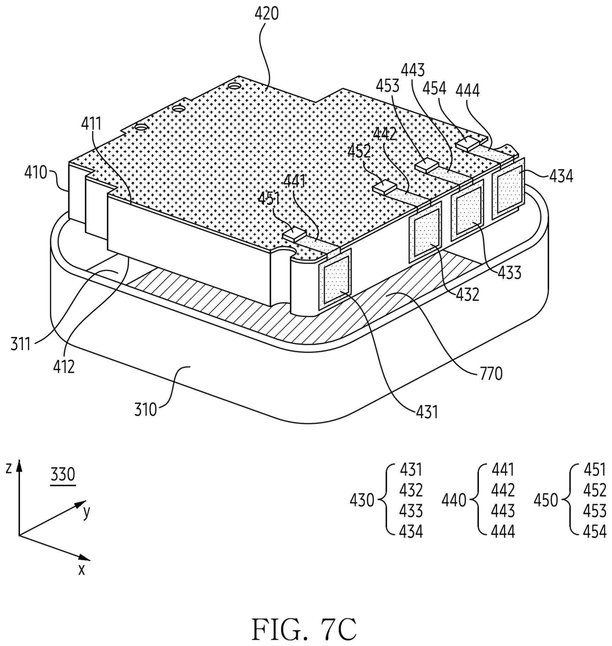

Referring to FIG. 7C, according to an embodiment, the electronic device 101 may include the support 410, the PCB 420, the wireless communication circuitry 425, the conductive patches 430, the connection structure 440, the connector 450, and a metal sheet 770. For the description of the support 410, the PCB 420, the wireless communication circuitry 425, the conductive patches 430, the connection structure 440, and the connector 450, FIG. 4A may be referred to. The first portion 411 of the support 410 may be configured to be coupled to the PCB 420. The support 410 may include the sidewall portions forming the predetermined height to support the PCB 420 substrate. The second portion 412 of the support 410 may be located in the opposite side of the first portion 411 of the support 410. In order to reduce a performance difference between materials of a bottom surface and to utilize an effect of gain improvement by a metal layer (e.g., the metal surface 610), the metal layer may be disposed above a surface (e.g., a surface facing the +z axis direction of the first plate 311 of the housing 300) of a case 310. The metal sheet 770 may be used as ground. For example, the metal sheet 770 may be configured with a copper or aluminum material. The second portion 412 of the support 410 may be coupled to the metal sheet 770. The metal sheet 770 may be located below with respect to the conductive patches 430 disposed on the side portion 415.

In FIGS. 7A to 7C, although the ground substrate 710, the metal layer of the PCB 420, and the metal sheet 770 are exemplified as a metal layer located below the conductive patches 430, embodiments of the present disclosure are not limited thereto. According to an embodiment, the electronic device 101 may include a conductive member for controlling heat generation. For example, the conductive member may include a heatsink, a heat dissipation material of a battery, and/or a graphite sheet. To disperse the generated heat, the conductive member may be configured with a metal material having high conductivity. For example, the conductive member may be configured with aluminum, copper, or iron. As the conductive member is disposed at a location spaced apart from the conductive patches 430 in a direction (e.g., the -z axis direction) by a predetermined distance (e.g., half a wavelength of a signal) or more, a signal gain of a vertical polarization component with respect to the metal layer may increase.

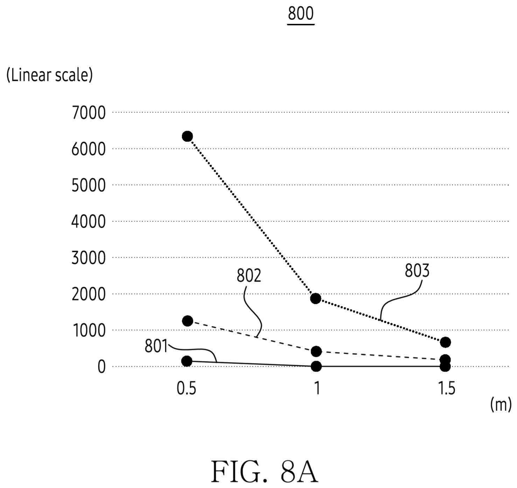

FIG. 8A indicates an example of a performance of conductive patches of an electronic device (an electronic device 101).

Referring to FIG. 8A, a graph 800 indicates signal sensitivity according to a distance. A horizontal axis of the graph 800 indicates a distance (unit: meter), and a vertical axis of the graph 800 indicates sensitivity (unit: milliwatt (mW)). A first line 801 indicates a sensitivity performance of an antenna (e.g., a monopole antenna) of a bar-type terminal disposed above a table. A second line 802 indicates a sensitivity performance of the antenna (e.g., the monopole antenna) of the bar-type terminal on a free space. A third line 803 indicates a sensitivity performance of the electronic device 101 in which a metal layer is disposed in a first plate 311 of a housing 300. When comparing the first line 801 and the third line 803, it may be identified that the electronic device 101 has improvement of reception sensitivity of about 50 times compared to the antenna of the bar-type terminal. Considering that a difference in antenna efficiency between the antenna of the terminal and an antenna (e.g., the conductive patches 430) of the electronic device 101 is about 5 dB (decibel), it may be identified that recognition sensitivity of the electronic device 101 is increased by about 10 times or more compared to the bar-type terminal. In addition, comparing the second line 802 and the third line 803 when considering the antenna efficiency, it may be identified that the electronic device 101 disposed on the table provides the same level of performance as the terminal disposed in the free space.

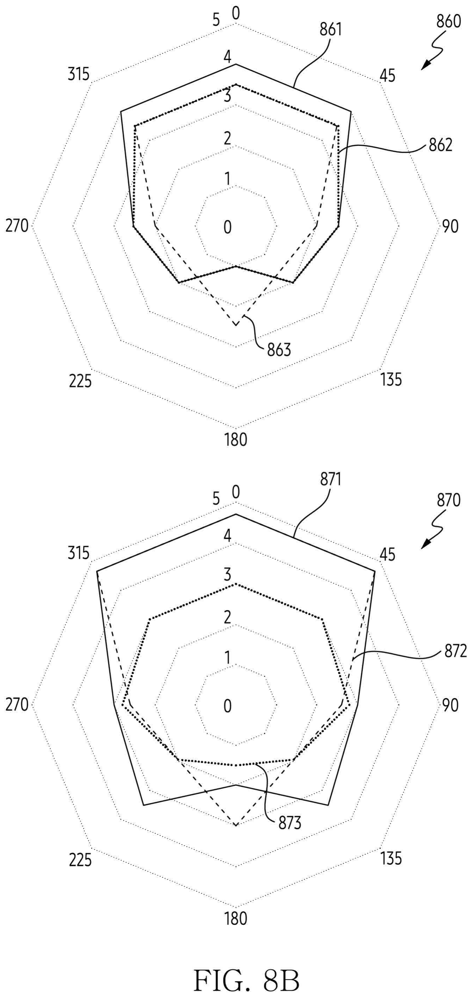

FIG. 8B illustrates an example of a recognition distance performance according to a material of a bottom surface of the electronic device (e.g., the electronic device 101). A beam width of conductive patches may vary according to a polarization. A horizontal polarization may provide a relatively wide beam width compared to a vertical polarization. A wide field of view (FoV) may be required to stably provide a service using a radar function. The electronic device 101 may provide a circular polarization including both the vertical polarization and the horizontal polarization in order to have high antenna efficiency on a bottom (e.g., a metal surface 610) of a metal material, and to obtain the wide FOV. In FIG. 8B, an example of a performance according to the material of the bottom surface and a polarization is described. To verify an actual performance, the performance is measured in a situation where a center region (a region including the center of an antenna) of the antenna is about 12 mm apart from the bottom surface (=about 0.35 λ) in a frequency band of about 8 GHz.

Referring to FIG. 8B, a first result 860 indicates a result of performing occupancy detection above a table of a wood material. A first line 861 indicates a recognition distance performance of a circular polarization antenna. A second line 862 indicates a recognition distance performance of a horizontal polarization antenna. A third line 863 indicates a recognition distance performance of a vertical polarization antenna. Since the circular polarization antenna may receive both a horizontal polarization component and a vertical polarization component, power received through the circular polarization antenna in the entire band increases. Therefore, it may be identified that the circular polarization antenna is dominant in a front direction. On the other hand, since the horizontal polarization provides the wide FoV, it may be identified that the horizontal polarization antenna is dominant in a lateral direction.

A second result 870 indicates a result of performing occupancy detection above a table of a metal material. A first line 871 indicates a recognition distance performance of the circular polarization antenna. A second line 872 indicates a recognition distance performance of the horizontal polarization antenna. A third line 873 indicates a recognition distance performance of the vertical polarization antenna. As described through FIG. 6, since the metal layer is located a predetermined distance from the conductive patches, it may be identified that the recognition distance performance of the vertical polarization antenna is superior to the recognition distance performance of the horizontal polarization antenna. Since the circular polarization antenna may receive both the horizontal polarization component and the vertical polarization component, it may be identified that circular polarization antennas provide the superior recognition distance performance compared to other antennas not only in the front but also in another direction.

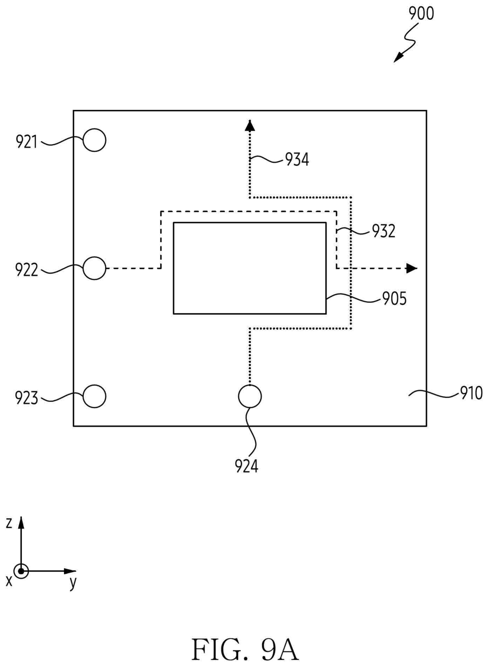

The electronic device 101 according to embodiments of the present disclosure may include an antenna structure including a conductive patch disposed on a side surface and providing a circular polarization, and a metal layer disposed below a conductive patch. Through the metal layer, a constant radar performance may be guaranteed regardless of the material of the bottom surface on which the electronic device 101 is mounted. A wide recognition distance of a radar may be secured through the circular polarization. In order to transmit or receive a signal of the circular polarization through the conductive patch, the conductive patch may have a shape for the circular polarization or signals for forming the circular polarization may be fed to the conductive patch. Hereinafter, an example of an antenna structure for the circular polarization will be described through FIGS. 9A to 10C.

FIGS. 9A to 9B indicate an example of a conductive patch for a circular polarization. A polarization indicates a direction of an electric field (E-field) of an electromagnetic wave. For example, the electromagnetic wave may include a first polarization component and a second polarization component perpendicular to the first polarization component. If a phase difference between the first polarization component and the second polarization component is about 90 degrees, a vector sum of the first polarization component and the second polarization component may form the circular polarization.

Referring to FIG. 9A, a conductive patch 900 may provide the circular polarization. In order to form the circular polarization, the conductive patch 900 may provide signals of two polarizations perpendicular to each other. A phase difference between the two polarizations may be about 90 degrees. For example, when a signal is fed to a feeding point (e.g., a third point 923), the conductive patch 900 may radiate a first signal of a first polarization in a first direction (e.g., a +y axis) and may radiate a second signal of a second polarization in a second direction (e.g., a +z axis). The first polarization and the second polarization may be substantially perpendicular to each other. As an example, the first polarization may correspond to a horizontal polarization, and the second polarization may correspond to a vertical polarization. As another example, the first polarization may correspond to a +45 degrees polarization, and the second polarization may correspond to a -45 degrees polarization. In order to form a phase difference between the first polarization and the second polarization, the conductive patch 900 may have an asymmetric shape. For example, an appearance of the conductive patch 900 may be a quadrilateral, and a slot 905 may be formed inside the quadrilateral. The slot 905 may be asymmetrical in the first direction (e.g., the +y axis) and the second direction (e.g., the +z axis). A first length of the slot 905 in the first direction may be smaller than a second length of the slot 905 in the second direction.

A signal of the circular polarization may be generated based on a constant phase difference (e.g., a phase difference of about 90 degrees) of signals of two polarizations orthogonal to each other. The signals may include the first signal of the first polarization and the second signal of the second polarization. A phase of the first signal and a phase of the second signal vary according to a location where a signal is fed (i.e., a feeding point) in the conductive patch 900. A phase difference between the first polarization and the second polarization may vary according to the feeding point. Accordingly, a polarization of the signal may vary according to the location where the signal is fed in the conductive patch 900. For example, a signal may be fed to a first point 921. According to the signal, the signal may flow in a +y axis direction and the signal may flow in a -z axis direction in the conductive patch 900. Due to the signal fed to the conductive patch 900, an electric field may be formed. Based on a phase difference between a component with respect to the +y axis direction (e.g., a horizontal component) and a component (e.g., a vertical component) with respect to the -z axis direction of the electric field, the conductive patch 900 may radiate a signal of the circular polarization. The conductive patch 900 may radiate a signal of a left hand circular polarization (LHCP). For example, a signal may be fed to a second point 922. According to the signal, an electric field by the conductive patch 900 may be formed symmetrically with respect to the +y axis direction. The conductive patch 900 may radiate a signal of the horizontal polarization. For example, a signal may be fed to a third point 923. According to the signal, the signal may flow in the +y axis direction and the signal may flow in the +z axis direction in the conductive patch 900. Due to the signal fed to the conductive patch 900, an electric field may be formed. Based on a phase difference between a component (e.g., a horizontal component) with respect to the +y axis direction and a component (e.g., a vertical component) with respect to the +z-axis direction of the electric field, the conductive patch 900 may radiate a signal of the circular polarization. The conductive patch 900 may radiate a signal of a right hand circular polarization (RHCP). For example, a signal may be fed to a fourth point 924. According to the signal, an electric field by the conductive patch 900 may be symmetrically formed with respect to the +z axis direction. The conductive patch 900 may radiate a signal of the vertical polarization.

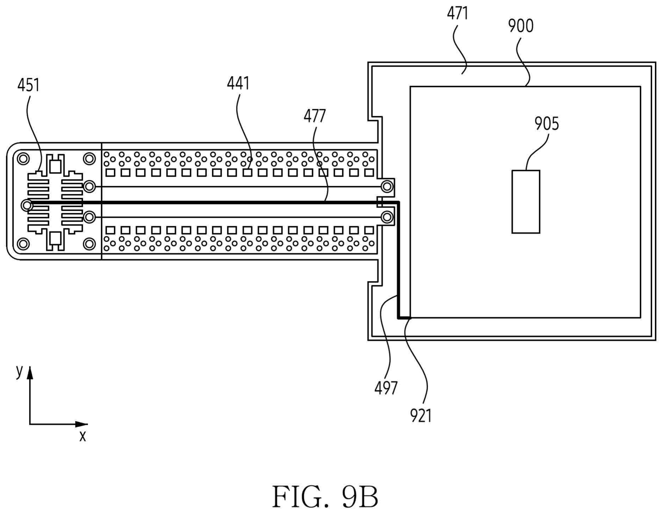

In FIG. 9B, an example in which the conductive patch 900 of FIG. 9A is disposed on an FPCB (e.g., a first FPCB 441) is described. Referring to FIG. 9B, the first FPCB 441 may be configured with a flexible material. The first FPCB 441 may include a cable portion 481 and a plate portion 491. For description of the first FPCB 441, FIG. 4C may be referred to. The cable portion 481 may include a feeding line 487. A signal may be transmitted to the conductive patch 900 through the feeding line 487. The conductive patch 900 may be disposed above a surface of the plate portion 491. The feeding line 497 may be connected to the feeding line 487 of the cable portion 481. The feeding line 497 may provide a signal to a region (e.g., a feeding point 921) for a circular polarization of the conductive patch 900. The conductive patch 900 may be configured to radiate a signal of the circular polarization. For example, the conductive patch 900 may radiate a signal of the LHCP.

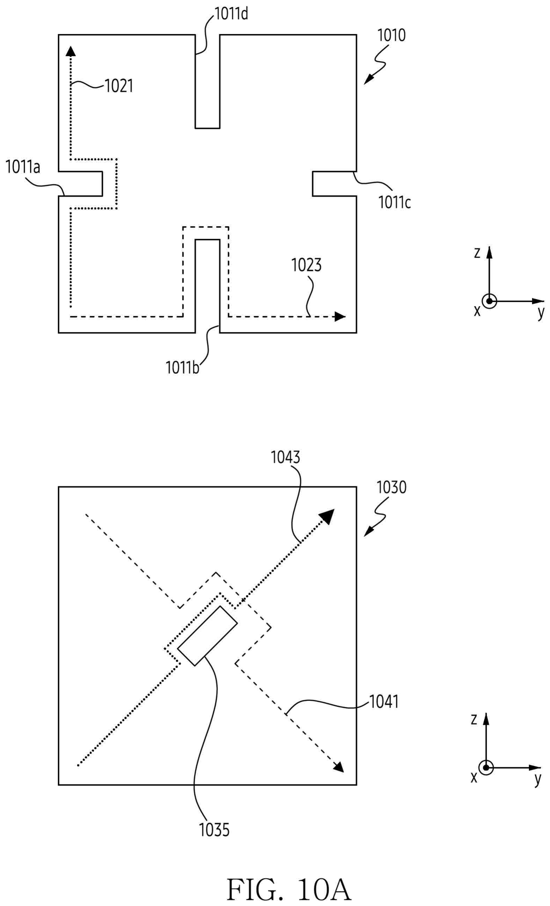

FIGS. 10A to 10C indicate other examples of a conductive patch for a circular polarization.

Referring to FIG. 10A, a conductive patch 1010 may be configured to radiate a signal of the circular polarization. The conductive patch 1010 may include a slit. For example, the conductive patch 1010 may include four slits (e.g., a slit 1011a, a slit 1011b, a slit 1011c, and a slit 1011d). For asymmetry, a length of the slit 1011a may be different from a length of the slit 1011b. For asymmetry, a length of the slit 1011c may be different from a length of the slit 1011d. A signal may be fed to a feeding point of the conductive patch 1010. Based on the signal, a first signal may flow along a first path 1021, and a second signal may flow along a second path 1023. Since a length of the first path 1021 and a length of the second path 1023 are different, a phase of the first signal flowing along a +y axis direction may be different from a phase of the second signal flowing along a +z axis direction. Based on a phase difference between the first signal and the second signal, a phase difference may occur between a first polarization component (e.g., a horizontal polarization) and a second polarization component (e.g., a vertical polarization) of the radiated signal. The conductive patch 1010 may radiate a signal of the circular polarization, based on the phase difference.

A conductive patch 1030 may be configured to radiate a signal of the circular polarization. The conductive patch 1030 may include a slot. Based on a phase difference between a +45 degrees polarization and a -45 degrees polarization, as well as the horizontal polarization and the vertical polarization, the circular polarization may be generated. For asymmetry, a first length 1035a of a slot 1035 may be different from a second length 1035b of the slot 1035. A signal may be fed to a feeding point of the conductive patch 1030. Based on the signal, a first signal may flow along a first path 1041, and a second signal may flow along a second path 1043. Since a length of the first path 1041 and a length of the second path 1043 are different, a phase difference between the first polarization component (e.g., the -45 degrees polarization) and the second polarization component (e.g., the +45 degrees polarization) may occur. The conductive patch 1030 may radiate a signal of the circular polarization based on the phase difference.

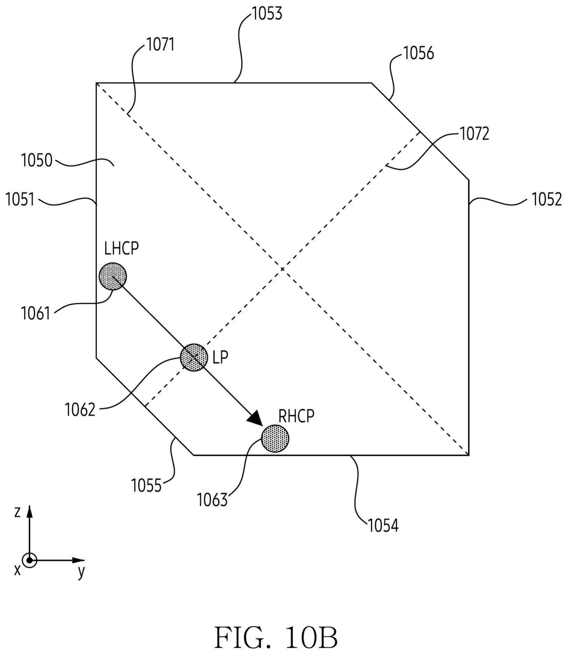

Referring to FIG. 10B, a conductive patch 1050 may be configured to radiate a signal of the circular polarization. A shape of the conductive patch 1050 may be a polygon. For example, the conductive patch 1050 may have a shape in which at least one corner region is cut in a quadrilateral patch. The corner region is an end portion of the quadrilateral patch and refers to a region including a vertex. A region (e.g., a fifth side 1055 or a sixth side 1056) corresponding to the cut shape may be referred to as a cut region. Due to the at least one corner region, a phase of the first polarization component and a phase of the second polarization component may vary. For example, the polygon may include a hexagon. The polygon may include a first side 1051 and a second side 1052 disposed along a first direction (e.g., a y axis). The polygon may include a third side 1053 and a fourth side 1054 disposed along a second direction (e.g., a z axis) perpendicular to the first direction. The first side 1051 may be connected to the third side 1053, and the second side 1052 may be connected to the fourth side 1054. The polygon may include the fifth side 1055 connected to the first side 1051 and the fourth side 1054. The polygon may include the sixth side 1056 connected to the second side 1052 and the third side 1053.

A signal fed through the conductive patch 1050 may include a signal component of a first polarization 1071 and a signal component of a second polarization 1072. Since a phase of the signal component of the first polarization 1071 and a phase of the signal component of the second polarization 1072 vary according to a location of a feeding point, various polarizations may be formed. For example, when a signal is fed to a first feeding point 1061, the phase of the signal component of the first polarization 1071 may be about 90 degrees greater than the phase of the signal component of the second polarization 1072. A signal of an LHCP may be generated based on the signal fed to the first feeding point 1061. For example, when a signal is fed to the second feeding point 1062, the signal component of the first polarization 1071 and the signal component of the second polarization 1072 may be symmetrical with respect to a direction of the second polarization 1072. The phase of the signal component of the first polarization 1071 and the phase of the signal component of the second polarization 1072 may correspond to each other. Signal components for the first polarization 1071 may be offset by each other to generate a signal of a linear polarization (LP) (e.g., the second polarization 1072). For example, when a signal is fed to the third feeding point 1063, the phase of the signal component of the first polarization 1071 may be about 90 degrees smaller than the phase of the signal component of the second polarization 1072. A signal of an RHCP may be generated based on the signal fed to the third feeding point 1063.

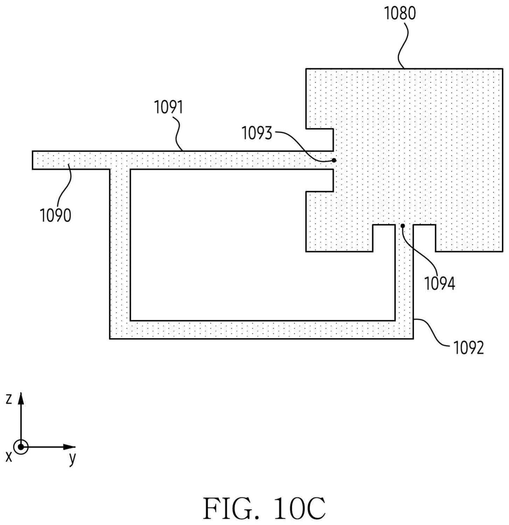

Referring to FIG. 10C, a conductive patch 1080 may be configured to radiate a signal of the circular polarization. A feeding line 1090 may branch to a first feeding line 1091 and a second feeding line 1092. The conductive patch 1080 may include feeding points (e.g., a feeding point 1093 and a feeding point 1094) for dual feeding. A length of the second feeding line 1092 may be different from a length of the first feeding line 1091. A difference between the length of the second feeding line 1092 and the length of the first feeding line 1091 may be about λ/4 (the λ is a length of a wavelength of a signal). A signal of the feeding line 1090 may be provided to each of the first feeding line 1091 and the second feeding line 1092. Based on the first feeding line 1091 and the second feeding line 1092, signals having a phase difference of about 90 degrees may be fed to the conductive patch 1080. A phase difference between a signal fed to the feeding point 1093 and a signal fed to the feeding point 1094 may be about 90 degrees. The circular polarization may be generated based on the phase difference. For dual feeding, the FPCB of FIG. 4C (e.g., the first FPCB 441) may be used. For example, the feeding line 1090 may be disposed in a region (e.g., the cable portion 481) of the FPCB. The first feeding line 1091 and the second feeding line 1092 may be disposed in a region (e.g., the cable portion 481 or the plate portion 491) of the FPCB. Dual feeding may be provided to the conductive patch 1080 through a conductive pattern for the first feeding line 1091 and the second feeding line 1092 in the FPCB.

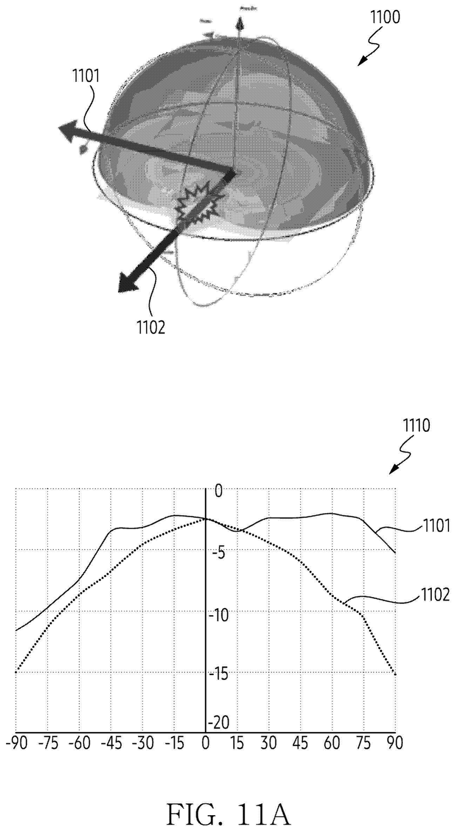

FIG. 11A indicates an example of a radiation pattern for each polarization.

Referring to FIG. 11A, a radiation pattern 1100 may include a first component 1101 in a polarization direction and a second component 1102 in a direction orthogonal to the polarization. A graph 1110 indicates a gain of a radiation pattern. A horizontal axis of the graph 1110 indicates an angle and a vertical axis indicates a gain (unit: decibel isotropic (dBi)). A first line 1101 indicates a gain of the first component 1101 and a second line 1102 indicates a gain of the second component 1102. Referring to the graph 1110, it is identified that the gain of the first component 1101 is higher than the gain of the second component 1102 within a designated range (e.g., from about -90 degrees to about +90 degrees). In other words, it is advantageous to radiate or receive a signal in the polarization direction. A wide field of view (FoV) may be required to stably provide a service using a radar function. For the wide FoV with respect to a horizontal direction, it is required to radiate a signal of a horizontal polarization. An electronic device 101 may provide a circular polarization including both a vertical polarization and the horizontal polarization in order to have high antenna efficiency on a bottom surface (e.g., the metal surface 610) of a metal material and to obtain the wide FOV.

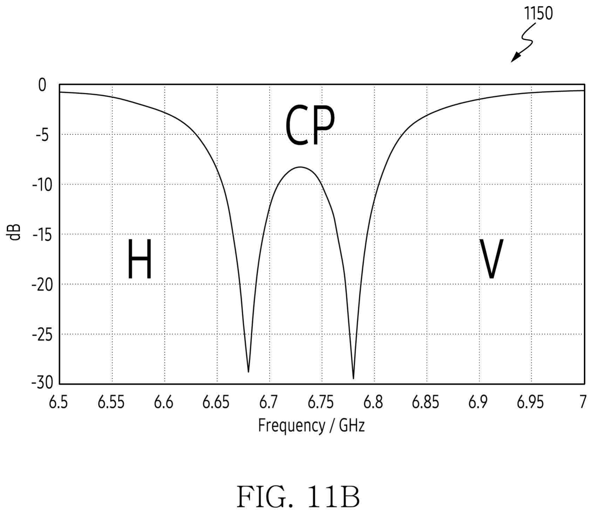

FIG. 11B indicates an example of a gain for each frequency.

Referring to FIG. 11B, a graph 1150 indicates a gain for each frequency. A horizontal axis of the graph 1150 indicates a frequency (unit: gigahertz (GHz)), and a vertical axis indicates a gain (unit: decibel (dB)). The gain of the vertical axis may indicate an S-parameter (e.g., S21). An antenna for a circular polarization operate as a circular polarization in a center frequency (e.g., about 6.7 to 6.75 GHz), but may operate as a linear polarization perpendicular to each other in a frequency away from the circular polarization. For example, in a first frequency range (e.g., about 6.65 or less), the antenna may operate as a horizontal polarization. For example, in a second frequency range (e.g., about 6.8 or more), the antenna may operate as a vertical polarization. The antenna may have different polarizations according to a frequency. For example, an electronic device 101 may transmit a signal in a UWB band. Due to a nature of the UWB band, a wide bandwidth of about 500 MHz or more is used, so the antenna for the circular polarization may provide various polarizations within a UWB channel. The electronic device 101 may utilize an advantage of the various polarizations.

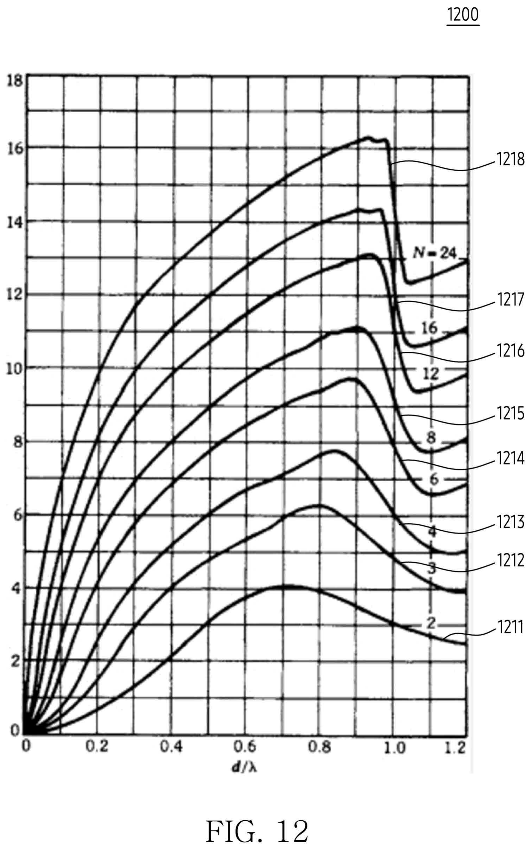

FIG. 12 illustrates an example of directivity according to a distance between antennas.

Referring to FIG. 12, a graph 1200 indicates directivity according to a distance between antennas. A horizontal axis of the graph 1200 indicates a distance between antennas in a wavelength unit (unit: d/λ, d is the distance between the antennas, λ is a wavelength of a signal), and a vertical axis of the graph 1200 indicates a gain (unit: dB) of a boresight direction. A line 1211 indicates directivity of two antennas. A line 1212 indicates directivity of three antennas. A line 1213 indicates directivity of four antennas. A line 1214 indicates directivity of six antennas. A line 1215 indicates directivity of eight antennas. A line 1216 indicates directivity of twelve antennas. A line 1217 indicates directivity of sixteen antennas. A line 1218 indicates directivity of twenty-four antennas.

Referring to the graph 1200, an antenna gain increases as a distance between antennas increases up to a predetermined distance. When a distance between antennas becomes about a wavelength distance, the gain decreases as a grating lobe is formed. The grating lobe refers to an unnecessary component in addition to a component in addition to a main lobe corresponding to a boresight among beam patterns generated in an array antenna. Since a gain of the main lobe gets lower as a gain of the grating lobe is greater, directivity gets lower. For example, in order to provide high directivity, a distance between antennas in a range of about λ/2 (λ is the wavelength of the signal) to about λ may be preferred. Since a polarization in a direction perpendicular to a metal layer (e.g., a metal surface 610) forms an image current in the same direction, currents may form different radiation patterns according to a distance between the metal layer and the antenna. The image current may be understood that a virtual antenna (hereinafter, an image antenna) exists symmetrically in a region opposite to the antenna with respect to the metal layer. Therefore, in a case that the distance between the antenna and the metal layer (e.g., the metal surface 610) is designed to be more than or equal to about half the wavelength, the electronic device 101 may secure a high gain due to the image current.

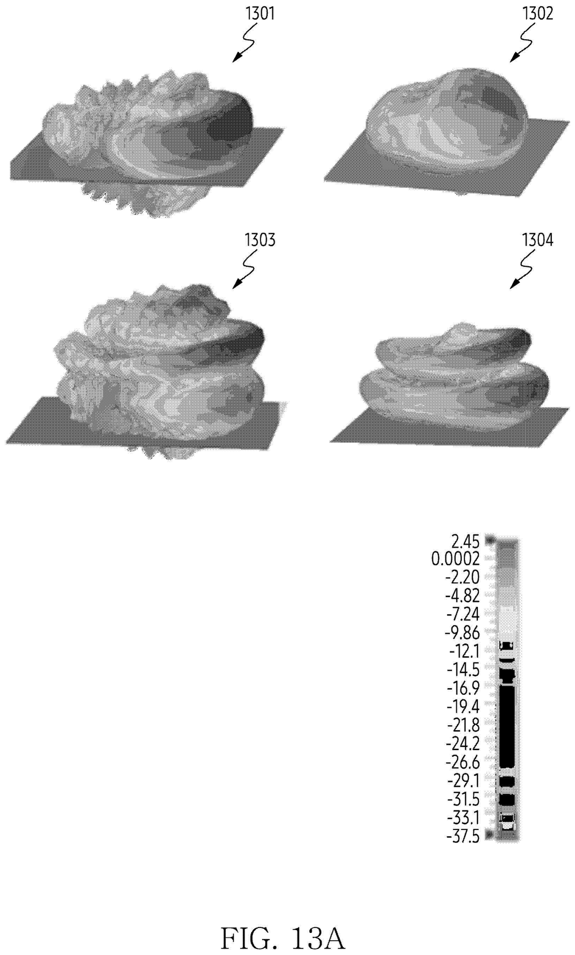

FIGS. 13A to 13B indicate examples of a radiation pattern according to a polarization and a wavelength.

Referring to FIG. 13A, a first radiation pattern 1301 indicates a radiation pattern of a signal in which a distance between an antenna and an image antenna (i.e., two times a distance between a center region (e.g., in a case of the conductive patch 900 of FIG. 9A, a hole region) of the antenna and a metal layer (e.g., a metal surface 610)) is λ/2 (λ is a wavelength of the signal) and is a vertical polarization. A second radiation pattern 1302 indicates a radiation pattern of a signal in which the distance between the antenna and the image antenna (e.g., twice the distance between the center region of the antenna and the metal layer) is λ/2 (λ is a wavelength of a signal) and is a horizontal polarization. Comparing the first radiation pattern 1301 and the second radiation pattern 1302, it is identified that a signal of the vertical polarization provides a higher gain in a front direction than a signal of the horizontal polarization.

A third radiation pattern 1303 indicates a radiation pattern of a signal in which the distance between the antenna and the image antenna (e.g., twice the distance between the center region of the antenna and the metal layer) is 2λ (λ is a wavelength of a signal) and is the vertical polarization. A fourth radiation pattern 1304 indicates a radiation pattern of a signal in which the distance between the antenna and the image antenna (e.g., twice the distance between the center region of the antenna and the metal layer) is 2λ (λ is a wavelength of a signal) and is a horizontal polarization. Comparing the first radiation pattern 1301 and the third radiation pattern 1303, it may be identified that a ripple occurs in a pattern due to a grating lobe as the distance between the antenna and the metal layer increases. Similarly, comparing the second radiation pattern 1302 and the fourth radiation pattern 1304, it may be identified that the ripple occurs as the distance between the antenna and the metal layer increases. Since the ripple causes an unwanted region to be detected by a radar, a probability of false detection increases.

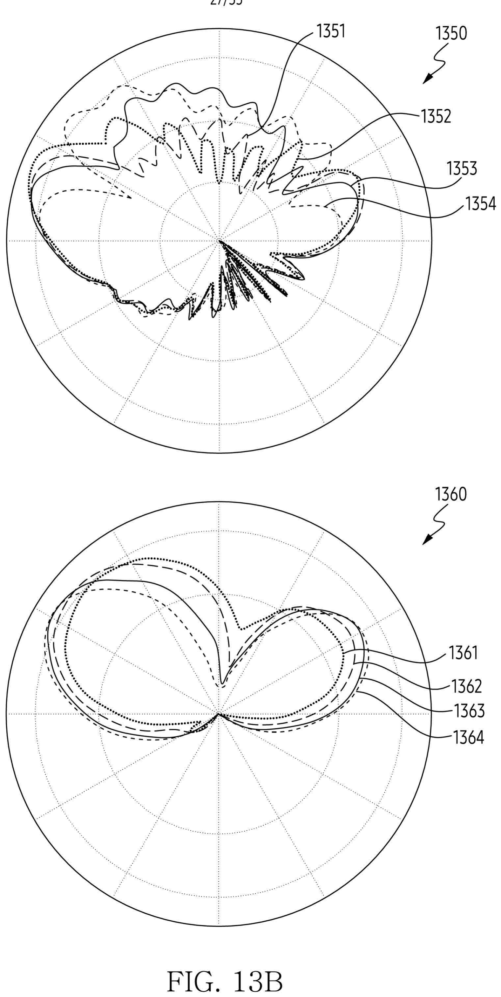

Referring to FIG. 13B, a graph 1350 indicates a radiation pattern of a vertical polarization for each wavelength. A front direction is about 0 degrees, a lower direction is about 90 degrees, a rear direction is about 180 degrees, and an upper direction is about 270 degrees. A first pattern 1351 indicates a radiation pattern of the vertical polarization when the distance between the antenna and the image antenna (e.g., twice the distance between the center region of the antenna and the metal layer) is λ/3 (λ is a wavelength of a signal). A second pattern 1351 indicates a radiation pattern of the vertical polarization when the distance between the antenna and the image antenna (e.g., twice the distance between the center region of the antenna and the metal layer) is λ/2. A third pattern 1351 indicates a radiation pattern of the vertical polarization when the distance between the antenna and the image antenna (e.g., twice the distance between the center region of the antenna and the metal layer) is λ. A fourth pattern 1351 indicates a radiation pattern of the vertical polarization when the distance between the antenna and the image antenna (e.g., twice the distance between the center region of the antenna and the metal layer) is 2λ. Referring to the graph 1350, it may be identified that a signal gain in a direction different from the front direction increases as the distance between the antenna and the metal layer increases. Such a grating lobe may cause a malfunction of a service using a radar function. Accordingly, the electronic device 101 may include an antenna (e.g., conductive patches 430) disposed within a designated range (e.g., from about λ/4 to about λ/2) from the metal layer.

A graph 1360 shows a radiation pattern of a horizontal polarization for each wavelength. A front direction is about 0 degrees, a lower direction is about 90 degrees, a rear direction is about 180 degrees, and an upper direction is about 270 degrees. A first pattern 1361 indicates a radiation pattern of the horizontal polarization when the distance between the antenna and the image antenna (e.g., twice the distance between the center region of the antenna and the metal layer) is λ/3 (where λ is a wavelength of a signal). A second pattern 1361 indicates a radiation pattern of the horizontal polarization when the distance between the antenna and the image antenna (e.g., twice the distance between the center region of the antenna and the metal layer) is λ/2. A third pattern 1361 indicates a radiation pattern of the horizontal polarization when the distance between the antenna and the image antenna (e.g., twice the distance between the center area of the antenna and the metal layer) is λ. A fourth pattern 1361 indicates a radiation pattern of the horizontal polarization when the distance between the antenna and the image antenna (e.g., twice the distance between the center area of the antenna and the metal layer) is 2λ. Comparing the graph 1350 and the graph 1360, it may be identified that a beam in the front direction is inclined upward in the horizontal polarization. For a wide FoV of the horizontal polarization and directivity in the front direction, the electronic device 101 may include an antenna for a circular polarization (e.g., the patches of FIGS. 9A to 10C).

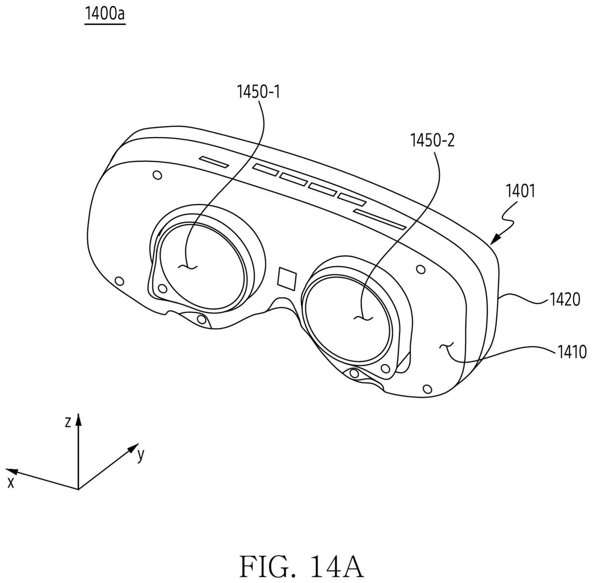

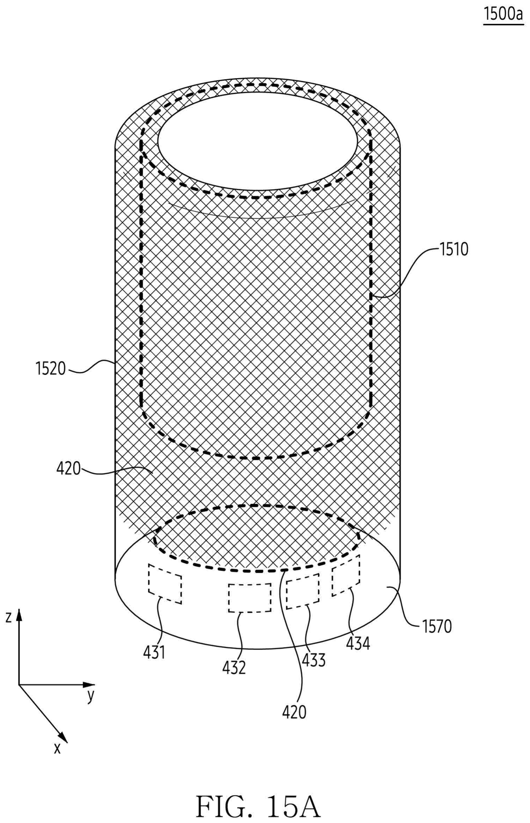

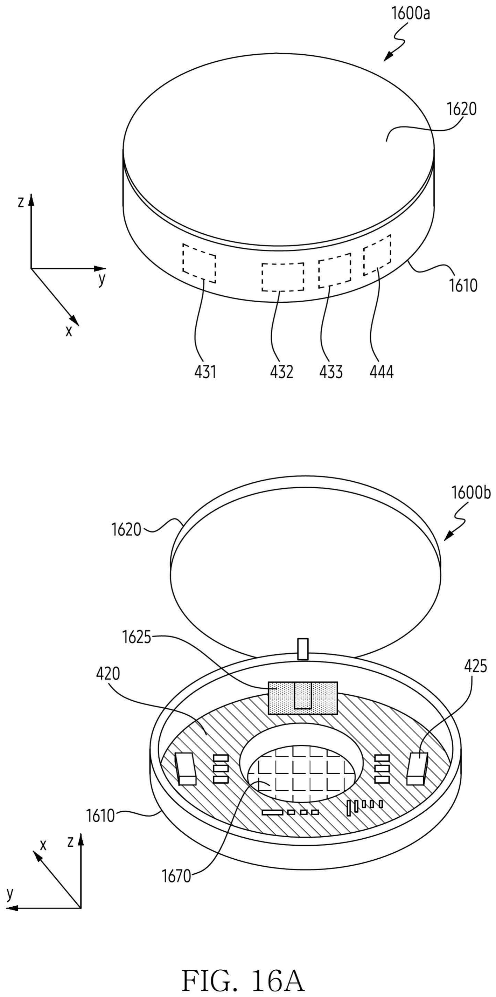

For a radar performance, conductive patches for the circular polarization may be disposed on a side surface of the electronic device 101, and a metal layer may be located at a location spaced apart at a predetermined interval (e.g., λ/2 to λ/4) from the conductive patches (e.g., a center region of a conductive patch). In addition to a hub device, various types of electronic devices may be used as the electronic device 101. An electronic device including disposition of the metal layer and the conductive patches may be understood as an embodiment of the present disclosure. Hereinafter, in FIGS. 14A to 14D, a wearable device will be described as an example, in FIGS. 15A to 15B, a speaker device will be described as an example, and in FIGS. 16A to 16B, a tag device will be described as an example.

FIGS. 14A to 14D indicate an example of a wearable device including a conductive patch for a circular polarization. An electronic device 101 may include the wearable device.

Referring to FIG. 14A, a diagram 1400a is a diagram of the wearable device viewed in a direction. A first surface 1410 of the wearable device may have an attachable shape on a user's body part (e.g., the user's face). Although not illustrated, the wearable device may further include a strap and/or one or more temples for being fixed on the user's body part. A first display 1450-1 for outputting an image to the left eye among both eyes of the user and a second display 1450-2 for outputting an image to the right eye among both eyes may be disposed on the first surface 1410. A wearable device 1400 may further include rubber or silicon packing formed on the first surface 1410 and to prevent interference by light (e.g., ambient light) different from light radiated from the first display 1450-1 and the second display 1450-2.

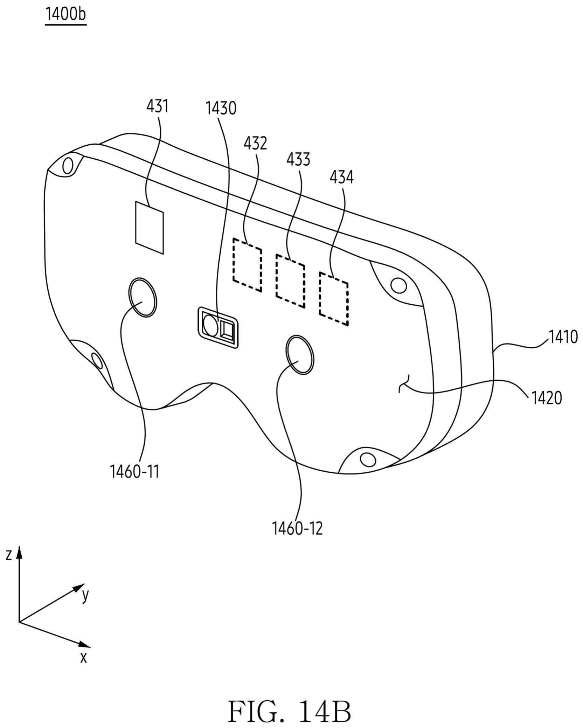

Referring to FIG. 14B, FIG. 14B indicates a view of the wearable device in a direction (e.g., a direction opposite to the direction of FIG. 14A). A camera (e.g., a camera 1460-1, or a camera 1460-2), and/or a sensor (e.g., a depth sensor 1430) may be disposed on the second surface 1420 opposite to the first surface 1410 of FIG. 14A to obtain information related to an external environment of the wearable device 1400. For example, the cameras 1460-1 and 1460-2 may be disposed on the second surface 1420 to recognize an external object. For example, using the cameras 1460-1 and 1460-2, the wearable device may obtain an image and/or a video to be transmitted to each of the user's eyes. The camera 1460-1 may be disposed on the second surface 1420 of the wearable device to obtain an image to be displayed through the second display 1450-2 corresponding to the right eye among both eyes. The camera 1460-2 may be disposed on the second surface 1420 of the wearable device to obtain an image to be displayed through the first display 1450-1 corresponding to the left eye among both eyes. The wearable device may include the depth sensor 1430 disposed on the second surface 1420 to identify a distance between the wearable device and the external object. Using the depth sensor 1430, the wearable device may obtain spatial information (e.g., a depth map) of at least a portion of an FoV of the user wearing the wearable device. Although not illustrated, a microphone for obtaining a sound outputted from the external object may be disposed on the second surface 1420 of the wearable device 101.

As described above, the wearable device 101 may include hardware (e.g., the camera 1460-1, or the camera 1460-2), and/or the sensor (e.g., the depth sensor 1430) for identifying the body part including the user's hand. The wearable device may identify a gesture displayed by a motion of the body part. The wearable device may provide the user wearing the wearable device with a user interface (UI) based on the identified gesture. The UI may support a function for editing an image and/or a video stored in the wearable device. The wearable device may communicate with an external electronic device different from the wearable device in order to more accurately identify the gesture.

The wearable device of FIGS. 14A and 14B may provide a virtual environment. For example, the virtual environment may indicate an example of extended reality (XR) provided through the wearable device. For example, the XR may include augmented reality (AR), virtual reality (VR), and mixed reality (MR). For example, the wearable device for the AR may augment and provide information based on a real object. For example, the wearable device may include AR glasses or VR glasses to provide the user with the information based on the real object. For example, the wearable device may include a video see-through (VST) device. To detect an object around the user who uses a service of the virtual environment and to recognize a spatial situation, the wearable device may provide a service using a radar function. The wearable device may include conductive patches (e.g., a first conductive patch 431, a second conductive patch 432, a third conductive patch 433, and a fourth conductive patch 434).

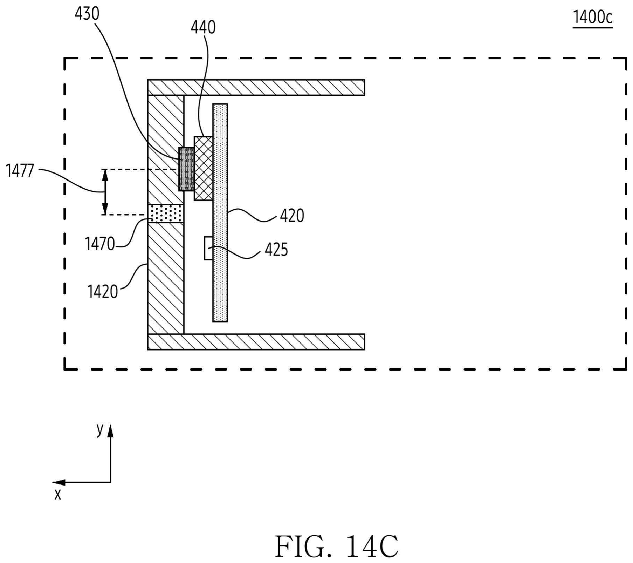

Referring to FIG. 14C, the wearable device may include a conductive patch (e.g., the conductive patch 430) for a circular polarization and a metal layer located below the conductive patch. A diagram 1400c is a cross-sectional view of the wearable device of FIGS. 14A and 14B viewed in a direction (e.g., a -x axis direction). The wearable device may include a PCB 420. A surface of the PCB 420 for mounting components may be disposed substantially parallel to the second surface 1420. The surface of the PCB 420 may be disposed to face in a direction (e.g., a +x axis direction). The wearable device may include the conductive patch 430. The conductive patch 430 may be disposed above a surface of a connection structure 440 (e.g., FPCB). The connection structure 440 may be connected to the PCB 420. Wireless communication circuitry (e.g., wireless communication circuitry 425) may be disposed above the surface of the PCB 420. For example, a signal from the wireless communication circuitry 425 may be provided to the conductive patch 430 through the connection structure 440. A metal layer 1470 may be disposed at a location spaced apart from the conductive patch 430 by a predetermined interval 1477. The metal layer 1470 may be formed on a portion of a housing having the second surface 1420 of the wearable device. For example, the metal layer 1470 may be disposed inside the housing in a form of a plating pattern, a metal via, and/or a metal substrate. Meanwhile, in FIG. 14C, the metal layer 1470 is illustrated to be located in A region of the housing, but embodiments of the present disclosure are not limited thereto. Unlike the illustration in FIG. 14C, it may also be understood as an embodiment of the present disclosure that the metal layer 1470 is located as a separate component inside the housing of the wearable device.

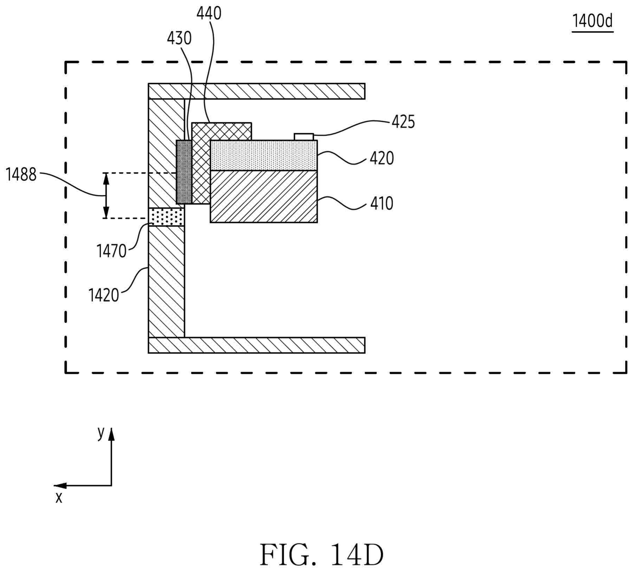

Referring to FIG. 14D, the wearable device may include a conductive patch (e.g., the conductive patch 430) for a circular polarization and a metal layer located below the conductive patch. A diagram 1400d is a cross-sectional view of the wearable device of FIGS. 14A and 14B viewed in a direction (e.g., the -x axis direction). The wearable device may include the PCB 420. Unlike FIG. 14C, the PCB 420 may be disposed such that a surface for mounting the components is substantially perpendicular to the second surface 1420 (or parallel to the ground). The wearable device may include a support 410 for supporting the PCB 420. For description of the support 410, the PCB 420, the wireless communication circuitry 425, the conductive patch 430, and the connection structure 440, FIG. 4A may be referred to. The metal layer 1470 may be disposed at a location spaced apart from the conductive patch 430 by a predetermined interval 1488. The metal layer 1470 may be formed on a portion of the housing having the second surface 1420 of the wearable device. For example, the metal layer 1470 may be disposed inside the housing in a form of a plating pattern, a metal via, and/or a metal substrate. Meanwhile, in FIG. 14D, the metal layer 1470 is illustrated to be located in a region of the housing, but embodiments of the present disclosure are not limited thereto. Unlike the illustration in FIG. 14C, it may also be understood as an embodiment of the present disclosure that the metal layer 1470 is located as a separate component inside the housing of the wearable device.

FIGS. 15A to 15B indicate an example of a speaker device including a conductive patch for a circular polarization. An electronic device 101 may include the speaker device. The speaker device may output a sound signal to the outside of the speaker device. With the development of technology, the speaker device may not only output a sound signal but also perform various functions for controlling various devices in a house or interacting with a user. For example, the speaker device may provide a service (e.g., streaming, or weather guidance) for a voice command of the user. For example, the speaker device may provide a service using radar technology, such as detecting a gesture of the user or analyzing a sleep pattern, and the like.

Referring to FIG. 15A, a diagram 1500a is a view of the speaker device in a front (e.g., a -x axis direction). The speaker device may include a housing 1510 and an audio module 1520 (e.g., an audio module 170). The audio module 1520 may convert a sound into an electrical signal, or conversely, convert an electrical signal into a sound. The audio module 1520 may be configured to output a voice signal by a processor of a PCB 420. For example, the audio module 1520 may include a diaphragm for converting an electrical signal into a sound wave and a magnet for moving the diaphragm. The speaker device may include a communication module to provide a service using radar technology. For example, the speaker device may include wireless communication circuitry 425 and conductive patches (e.g., a first conductive patch 431, a second conductive patch 432, a third conductive patch 433, and a fourth conductive patch 434). Like a hub device, the speaker device may be mounted on a bottom surface such as a table or a TV cabinet. It is required that a communication quality of the speaker device does not significantly change according to an environment of a mounted location. Considering an effect of a radiation pattern due to antenna efficiency and the bottom surface, the speaker device may include a metal layer 1570 disposed on a lower region spaced apart from conductive patches 430 by a predetermined distance.

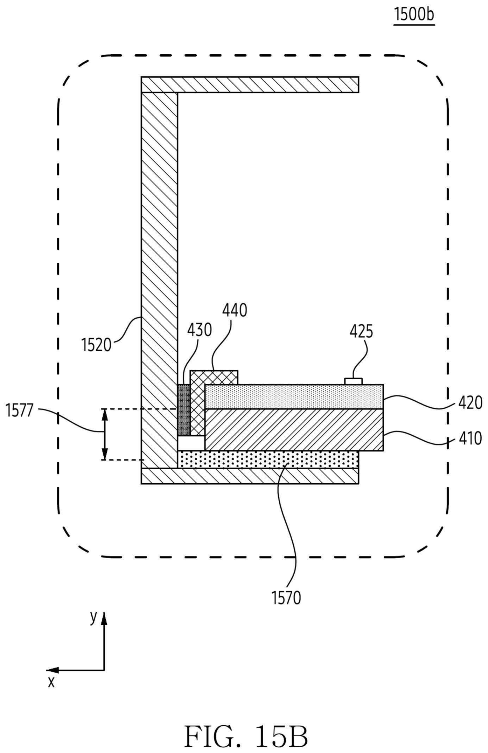

Referring to FIG. 15B, the speaker device may include a conductive patch (e.g., a conductive patch 430) for a circular polarization and a metal layer located below the conductive patch. A drawing 1500b is a cross-sectional view of the speaker device of FIG. 15A viewed in a direction (e.g., a -y axis direction). The speaker device may include the PCB 420. A surface of the PCB 420 for mounting the components may be disposed substantially parallel to the bottom surface (e.g., an xy plane). The surface of the PCB 420 may be disposed to face in a direction (e.g., a +z axis direction). The speaker device may include the conductive patch 430. The conductive patch 430 may be disposed on a surface of a connection structure 440 (e.g., the FPCB). The connection structure 440 may be connected to the PCB 420. The wireless communication circuitry (e.g., the wireless communication circuitry 425) may be disposed above the surface of the PCB 420. For example, a signal from the wireless communication circuitry 425 may be provided to the conductive patch 430 through the connection structure 440. The metal layer 1570 may be disposed at a location spaced apart from the conductive patch 430 by a predetermined interval 1577. Meanwhile, in FIG. 15B, the metal layer 1570 is illustrated to be located in the housing 1510, but embodiments of the present disclosure are not limited thereto. Unlike the illustration in FIG. 15B, it may also be understood as an embodiment of the present disclosure that the metal layer 1570 is formed of metal as a portion of the housing 1510 of the speaker device.

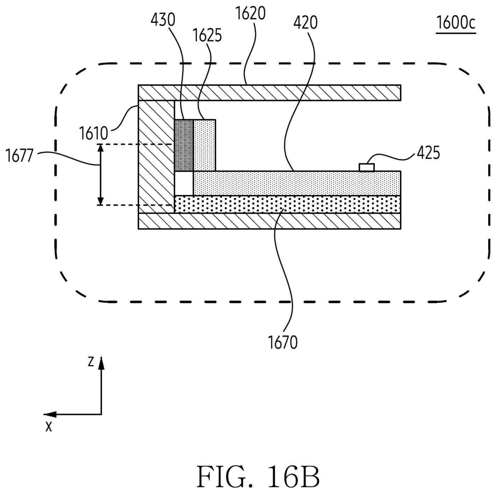

FIGS. 16A and 16B indicate an example of a tag device including a conductive patch for a circular polarization. An electronic device 101 may include the tag device. The tag device may provide a location tracking function based on communication technology (e.g., Bluetooth, or UWB). For example, the tag device may provide an external electronic device with location information of the tag device through a Bluetooth function. For example, the tag device may use a radar function. The tag device may transmit a signal in a UWB band to the external electronic device or receive a signal reflected from the external electronic device.

Referring to FIG. 16A, a diagram 1600a is a diagram of the tag device viewed from a front (e.g., a -x axis direction). The tag device may include a housing 1610 and a cover 1620. A drawing 1600b indicates an inside of the housing 1610. The tag device may include a communication module inside the housing 1610 to provide a service using radar technology. For example, the tag device may include a PCB 420, wireless communication circuitry 425, and conductive patches (e.g., a first conductive patch 431, a second conductive patch 432, a third conductive patch 433, and a fourth conductive patch 434) disposed on a side surface (e.g., a side facing a +x axis direction). Like a hub device, the tag device may be attached to a bag, a key ring, or the like and used to provide location information. A communication quality of the tag device may vary according to an attached environment. Considering an effect of a radiation pattern due to antenna efficiency and a bottom surface, the tag device may include a metal layer 1670 disposed on a lower region spaced apart from the conductive patches 430 by a predetermined distance.

Referring to FIG. 16B, the tag device may include a conductive patch (e.g., a conductive patch 430) for a circular polarization and a metal layer located below the conductive patch. A drawing 1600c is a cross-sectional view of the tag device of FIG. 16A viewed in a direction (e.g., a -y axis direction). The tag device may include the PCB 420. A surface of the PCB 420 for mounting the components may be disposed substantially parallel to the bottom surface (e.g., an xy plane). The surface of the PCB 420 may be disposed to face in a direction (e.g., a +z axis direction). The tag device may include the conductive patch 430. The conductive patch 430 may be disposed to face a lateral direction (e.g., the +x axis direction). For disposition of the conductive patch 430, the tag device may include a connection structure 1625 coupled to the PCB 420. The connection structure 1625 may include a conductive portion for feeding of a signal. Wireless communication circuitry (e.g., the wireless communication circuitry 425) may be disposed above the surface of the PCB 420. The connection structure 440 may be connected to the wireless communication circuitry 425 of the PCB 420. For example, a signal from the wireless communication circuitry 425 may be provided to the conductive patch 430 through the connection structure 1625. The metal layer 1670 may be disposed at a location spaced apart from the conductive patch 430 by a predetermined interval 1677. Meanwhile, in FIG. 16B, the metal layer 1670 is illustrated to be located in the housing 1610, but embodiments of the present disclosure are not limited thereto. It may also be understood as an example of the present disclosure that the metal layer 1670 is formed of metal as a portion of the housing 1610 of the tag device, unlike FIG 16B.

In the present disclosure, a UWB band has been described as an example for a radar function, but embodiments of the present disclosure are not limited thereto. In addition to wireless communication circuitry (e.g., wireless communication circuitry 425) for the UWB band, the above-described embodiments may also be applied to an mmWave band (e.g., a frequency range 2 band of a NR standard) or a terahertz band. A wavelength in the mmWave band or the terahertz band is shorter than a wavelength of a signal in the UWB band. For resonance in a higher frequency band than the UWB band, a size of a conductive patch may be smaller. In a case that embodiments of the present disclosure are applied in the mmWave band or the terahertz band, the size of the conductive patch and a required distance from the conductive patch to a metal surface may also be reduced due to a short wavelength.

According to embodiments of the present disclosure, a conductive patch for a circular polarization is disposed on a side surface, and a metal layer is located in a downward direction of the conductive patch, thereby a radar performance more than a certain level may be secured regardless of a material of a bottom surface.

The effects that can be obtained from the present disclosure are not limited to those described above, and any other effects not mentioned herein will be clearly understood by those having ordinary knowledge in the art to which the present disclosure belongs, from the following description.

In embodiments, an electronic device is provided. The electronic device may comprise a printed circuit board (PCB), a support including a first portion coupled to the PCB, a second portion opposite to the first portion, and a side portion between the first portion and the second portion, wireless communication circuitry disposed on the PCB, and a plurality of conductive patches disposed on a surface of the side portion of the support. The plurality of conductive patches may be electrically connected to the wireless communication circuitry. Each conductive path of the plurality of conductive patches may be configured to transmit or receive a signal of a circular polarization in a frequency band of the wireless communication circuitry. The first portion of the support or the second portion of the support may be coupled to a metal layer.

According to an embodiment, the metal layer coupled to the first portion of the support may comprise at least a portion of the PCB on which the wireless communication circuitry is disposed. The PCB may be used for ground.

According to an embodiment, the electronic device may further comprise a ground substrate disposed to the second portion of the support. The metal layer may comprise the ground substrate.

According to an embodiment, the electronic device may further comprise a metal sheet coupled to the second portion of the support. The metal layer may comprise the metal sheet.

According to an embodiment, the electronic device may further comprise a housing having a surface for supporting the electronic device. The metal layer may be disposed on the surface of the housing.

According to an embodiment, each conductive patch of the plurality of conductive patches may comprise a patch having a slot formed therein. A first length of the slot for a first polarization direction may be different from a second length of the slot for a second polarization direction which is perpendicular to the first polarization direction.

According to an embodiment, each conductive patch of the plurality of conductive patches may comprise a first side and a second side disposed along a first direction, a third side and a fourth side disposed along a second direction perpendicular to the first direction, and a fifth side and a sixth side. The first side may be connected to the third side. The second side may be connected to the fourth side. The fifth side may be connected to the first side and the fourth side. The sixth side may be connected to the second side and the third side.

According to an embodiment, the plurality of conductive patches may comprise a first conductive patch configured to transmit a first signal of the frequency band and one or more second conductive patches configured to receive a second signal of the frequency band.

According to an embodiment, a region of the plurality of conductive patches may be located within a designated range from the metal layer. The designated range may be greater than or equal to a 1/4 wavelength for a center frequency of the frequency band and less than or equal to a 1/2 wavelength for the center frequency of the frequency band.

According to an embodiment, the electronic device may further comprise a plurality of flexible printed circuit boards (FPCBs) corresponding to the plurality of conductive patches. Each FPCB of the plurality of FPCBs may include a feeding line for connecting the PCB and a corresponding conductive patch.

According to an embodiment, each FPCB of the plurality of FPCBs may include a cable portion and a plate portion connected to the cable portion. A conductive pattern to be electrically connected to the wireless communication circuitry may be formed on the PCB. A corresponding conductive patch may be disposed on a surface of the plate portion. The cable portion may be configured to be connected to the conductive pattern through a connector.

According to an embodiment, the support may be configured with a non-conductive portion.

According to an embodiment, the electronic device may further comprise a feeding structure, a module substrate coupled to the side portion of the support. The module substrate may include a feeding line for each conductive patch of the plurality of conductive patches. A conductive pattern for the wireless communication circuitry and a connector may be formed on the PCB. The feeding structure may be configured to electrically connect the module substrate and the conductive pattern.

According to an embodiment, the electronic device may further comprise a display. The electronic device may be a wearable device for providing a virtual environment through the display.

According to an embodiment, the electronic device may further comprise an audio module. The electronic device may be a speaker for outputting a sound signal to outside through the audio module.

In embodiments, an electronic device is provided. The electronic device may comprise a communication module for a designated frequency band, and a housing including a first plate for supporting the electronic device and a second plate opposite to the first plate. The communication module may include a printed circuit board (PCB), a support including a first portion coupled to the PCB, a second portion opposite to the first portion, and a side portion disposed in a space between the first portion and the second portion, and communication circuitry disposed on the PCB. The electronic device may include a plurality of conductive patches disposed on a surface of the side portion of the support. The plurality of conductive patches may be electrically connected to the communication circuitry. Each conductive path of the plurality of conductive patches may be configured to transmit or receive a signal of a circular polarization in a frequency band of the wireless communication circuitry. A metal layer may be disposed between the support and the first plate of the housing.

According to an embodiment, the metal layer coupled to the first portion of the support may comprise at least a portion of the PCB on which the communication circuit is disposed. The PCB may be disposed to face the first plate of the housing.

According to an embodiment, the metal layer coupled to the second portion of the support may comprise a metal sheet. The metal sheet may be disposed on the first plate of the housing.

According to an embodiment, a region of the plurality of conductive patches may be located within a designated range from the first plate of the housing. The designated range may be greater than or equal to a 1/4 wavelength for a center frequency of the frequency band and less than or equal to a 1/2 wavelength for the center frequency of the frequency band.

According to an embodiment, the housing may include a case for accommodating the communication module on the first plate and a cover having the second plate.

Methods according to embodiments described in claims or specifications of the present disclosure may be implemented as a form of hardware, software, or a combination of hardware and software.

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1. An electronic device, comprising;
a printed circuit board (PCB);
a support including a first portion coupled to the PCB, a second portion opposite to the first portion, and a side portion between the first portion and the second portion;
wireless communication circuitry disposed on the PCB; and
a plurality of conductive patches disposed on a surface of the side portion of the support, wherein the plurality of conductive patches are electrically connected to the wireless communication circuitry,
wherein each conductive path of the plurality of conductive patches is configured to transmit or receive a signal of a circular polarization in a frequency band of the wireless communication circuitry, and
wherein the first portion of the support or the second portion of the support is coupled to a metal layer.

2. The electronic device of claim 1,
wherein the metal layer coupled to the first portion of the support comprises at least a portion of the PCB on which the wireless communication circuitry is disposed, and
wherein the PCB is used for ground.

3. The electronic device of claim 1, further comprising:
a ground substrate disposed to the second portion of the support, and
wherein the metal layer comprises the ground substrate.

4. The electronic device of claim 1, further comprising:
a metal sheet coupled to the second portion of the support, and
wherein the metal layer comprises the metal sheet.

5. The electronic device of claim 4, further comprising:
a housing having a surface for supporting the electronic device, and
wherein the metal layer is disposed on the surface of the housing.

6. The electronic device of claim 1,
wherein each conductive patch of the plurality of conductive patches comprises a patch having a slot formed therein, and
wherein a first length of the slot for a first polarization direction is different from a second length of the slot for a second polarization direction which is perpendicular to the first polarization direction.

7. The electronic device of claim 1,
wherein each conductive patch of the plurality of conductive patches comprises:
a first side and a second side disposed along a first direction,
a third side and a fourth side disposed along a second direction perpendicular to the first direction, and
a fifth side and a sixth side,
wherein the first side is connected to the third side,
wherein the second side is connected to the fourth side,
wherein the fifth side is connected to the first side and the fourth side, and
wherein the sixth side is connected to the second side and the third side,

8. The electronic device of claim 1, wherein the plurality of conductive patches comprises a first conductive patch configured to transmit a first signal of the frequency band and one or more second conductive patches configured to receive a second signal of the frequency band.

9. The electronic device of claim 1,
wherein a region of the plurality of conductive patches is located within a designated range from the metal layer, and
wherein the designated range is greater than or equal to a 1/4 wavelength for a center frequency of the frequency band and less than or equal to a 1/2 wavelength for the center frequency of the frequency band.

10. The electronic device of claim 1, further comprising:
a plurality of flexible printed circuit boards (FPCBs) corresponding to the plurality of conductive patches, and
wherein each FPCB of the plurality of FPCBs includes a feeding line for connecting the PCB and a corresponding conductive patch.

11. The electronic device of claim 10,
wherein each FPCB of the plurality of FPCBs includes a cable portion and a plate portion connected to the cable portion,
wherein a conductive pattern to be electrically connected to the wireless communication circuitry is formed on the PCB,
wherein a corresponding conductive patch is disposed on a surface of the plate portion, and
wherein the cable portion is configured to be connected to the conductive pattern through a connector.

12. The electronic device of claim 10,
wherein the support is configured with a non-conductive portion.

13. The electronic device of claim 1, further comprising:
a feeding structure; and
a module substrate coupled to the side portion of the support,
wherein the module substrate includes a feeding line for each conductive patch of the plurality of conductive patches,
wherein a conductive pattern for the wireless communication circuitry and a connector is formed on the PCB, and
wherein the feeding structure is configured to electrically connect the module substrate and the conductive pattern,

14. The electronic device of claim 1, further comprising:
a display; and
wherein the electronic device is a wearable device for providing a virtual environment through the display.

15. The electronic device of claim 1, further comprising:
an audio module, and
wherein the electronic device is a speaker for outputting a sound signal to outside through the audio module.
